(19) Europäisches Patentamt
European Patent Office
Office européen des brevets

(11) **EP 4 534 508 A1**

(12) **EUROPEAN PATENT APPLICATION**
published in accordance with Art. 153(4) EPC

(43) Date of publication:
**09.04.2025 Bulletin 2025/15**

(21) Application number: **23816021.2**

(22) Date of filing: **29.05.2023**

(51) International Patent Classification (IPC):
***C04B 35/80*** (2006.01)    ***C04B 35/653*** (2006.01)

(52) Cooperative Patent Classification (CPC):
**C04B 35/653; C04B 35/80**

(86) International application number:
**PCT/JP2023/019942**

(87) International publication number:
**WO 2023/234264 (07.12.2023 Gazette 2023/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.05.2022 JP 2022088542**

(71) Applicants:
• **IHI Aerospace Co., Ltd.**
**Gunma 370-2398 (JP)**
• **Japan Aerospace Exploration Agency**
**Tokyo 182-8522 (JP)**

(72) Inventors:
• **KUBOTA, Yuki**
**Tokyo 135-0061 (JP)**
• **UDA, Michimasa**
**Tokyo 135-0061 (JP)**
• **TAKADA, Takuya**
**Tokyo 135-0061 (JP)**
• **AOKI, Takuya**
**Chofu-shi, Tokyo 182-8522 (JP)**

(74) Representative: **Grünecker Patent- und Rechtsanwälte**
**PartG mbB**
**Leopoldstraße 4**
**80802 München (DE)**

(54) **CERAMIC-BASED COMPOSITE MATERIAL AND METHOD FOR PRODUCING SAME**

(57)     To provide an innovative technique of producing a ceramic-based composite material including a matrix that has a heat resistance and in which formation of cracks is suppressed. A method for producing a ceramic-based composite material including a matrix and reinforcing fibers provided in the matrix includes disposing the reinforcing fibers in a liquid material for the matrix (step S2), heating the reinforcing fibers in the liquid material such that a temperature of the reinforcing fibers becomes a matrix forming temperature (step S31), and heating the reinforcing fibers in the liquid material such that a temperature of the reinforcing fibers becomes a heat resistance imparting temperature (step S32). The heat resistance imparting temperature is higher than the matrix forming temperature. The step S31 and the step S32 are repeated.

FIG. 4

EP 4 534 508 A1

## Description

### TECHNICAL FIELD

The present invention relates to a ceramic-based composite material that includes a matrix formed of ceramic and that includes reinforcing fibers provided in the matrix. In addition, the present invention relates to a method for producing a ceramic-based composite material.

### BACKGROUND ART

A ceramic-based composite material is used as a high-temperature structural member in a rocket engine, an aircraft jet engine, or the like. The ceramic-based composite material is a material that includes ceramic as a matrix and that includes reinforcing fibers provided in the matrix. An example used as the ceramic is silicon carbide.

One of methods for forming the matrix in the ceramic-based composite material is film boiling (FB). In the film boiling, for example, the matrix can be formed as follows. The reinforcing fibers are disposed in a liquid material (e.g., liquid polycarbosilane: LPCS) of the matrix, and the reinforcing fibers are heated in this state. As a result, the matrix formed of LPCS precipitates to be formed on the reinforcing fibers. Next, a heat treatment is performed on the reinforcing fibers on which the matrix has been formed in a heating furnace for example, at a high temperature (e.g., a high temperature equal to or higher than 1200°C). Thereby, the heat resistance of the matrix is improved. The film boiling is described in below-mentioned Non-Patent Literature 1, for example.

### CITATION LIST

### NON-PATENT LITERATURES

Non-Patent Literature 1: Min Mei et al. "Preparation of C/SiC composites by pulse chemical liquid-vapor deposition process", Materials Letters 82 (2012) 36-38

Non-Patent Literature 2: C. Besnarda et al. "Synthesis of hexacelsian barium aluminosilicate by film boiling chemical vapour process", Journal of the European Ceramic Society 40 (2020) 3494-3497

Non-Patent Literature 3: Masanori SHIMIZU et al. "Crystallization Behavior and Change in Surface Area of Alkoxide-Derived Mullite Precursor Powders with Different Compositions", Journal of the Ceramic Society of Japan 105 [2] 131-135 (1997)

## SUMMARY OF INVENTION

### TECHNICAL PROBLEM

When the heat treatment at the high temperature as described above is performed on the reinforcing fibers on which the matrix has been formed by the film boiling, the heat resistance of the matrix is improved, but a volume of the matrix shrinks so that thus cracks are formed in the matrix.

In addition, when the ceramic-based composite material is produced by the film boiling, the heat treatment for improving the heat resistance is additionally performed on the matrix in the heating furnace for example, after the formation of the matrix by the film boiling, as described above.

In view of the above, an object of the present invention is to provide a method for producing a ceramic-based composite material by film boiling in such a way that the ceramic-based composite material includes a matrix having a heat resistance even without performing an additional heat treatment after the film boiling.

In addition, an object of the present invention is to provide a ceramic-based composite material including a matrix where formation of cracks is suppressed while the matrix has heat resistance.

### SOLUTION TO PROBLEM

In order to achieve the above-described object, according to the present invention, there is provided a method for producing a ceramic-based composite material including a matrix and reinforcing fibers provided in the matrix, the method including:

a step (A) of disposing the reinforcing fibers in a liquid material for the matrix;
a step (B) of heating the reinforcing fibers in the liquid material such that a temperature of the reinforcing fibers becomes a matrix forming temperature; and
a step (C) of heating the reinforcing fibers in the liquid material such that a temperature of the reinforcing fibers becomes a heat resistance imparting temperature, wherein
the heat resistance imparting temperature is a temperature higher than the matrix forming temperature, and the method comprises repeating the step (B) and the step (C).

According to the present invention, there is provided a ceramic-based composite material that has been produced by this method.

### ADVANTAGEOUS EFFECTS OF INVENTION

The production method according to the present invention can produce a ceramic-based composite material including a matrix having a heat resistance even without an additional heat treatment after film boiling.

The ceramic-based composite material according to the present invention includes a matrix where formation of cracks is suppressed while the matrix has a heat resistance.

## BRIEF DESCRIPTION OF DRAWINGS

FIG. 1 is an enlarged schematic configuration diagram illustrating a section of a ceramic-based composite material according to an embodiment of the present invention.

FIG. 2A is a 2A-2A sectional view in FIG. 1.

FIG. 2B illustrates unit regions in the section of FIG. 2A, for a case of the present embodiment.

FIG. 2C corresponds to FIG. 2B, but illustrates a reference example.

FIG. 3 corresponds to a partially enlarged view of FIG. 1.

FIG. 4 is a flowchart illustrating a method for producing the ceramic-based composite material according to the embodiment of the present invention.

FIG. 5A illustrates a configuration example of an attachment tool used in the production method according to the embodiment of the present invention.

FIG. 5B is a 5B-5B arrow view in FIG. 5A.

FIG. 5C is a 5C-5C arrow view in FIG. 5A.

FIG. 6 illustrates a state where the attachment tool of FIG. 5A is disposed inside a treatment vessel that holds a liquid material.

FIG. 7 is a graph illustrating a temperature change in film boiling according to an implementation example.

FIG. 8A to FIG. 8E are images that concern a ceramic-based composite material fabricated by the implementation example, and that were acquired using a scanning electron microscope.

FIG. 9 is a graph representing a temperature change in film boiling according to a comparison example 1.

FIG. 10A to FIG.10E are images that concern a ceramic-based composite material fabricated by the comparison example 1, and that were acquired using the scanning electron microscope.

FIG. 11 is a graph representing a temperature change in film boiling according to a comparison example 2.

FIG. 12A to FIG. 12E are images that concern a ceramic-based composite material obtained in Comparison Example 2, and that were acquired the scanning electron microscope.

FIG. 13A is an image that concerns the ceramic-based composite material according to the implementation example before a heat exposure test, and that was acquired using the scanning electron microscope.

FIG. 13B is an image that concerns the ceramic-based composite material according to the implementation example after the heat exposure test, and that was acquired using a scanning electron microscope.

FIG. 14 is another image that concerns the ceramic-based composite material according to the implementation example after the heat exposure test, and that was acquired using the scanning electron microscope.

FIG. 15A is an image that concerns the ceramic-based composite material according to the comparison example 1 before a heat exposure test, and that was acquired using a scanning electron microscope.

FIG. 15B is an image that concerns the ceramic-based composite material according to the comparison example 1 after the heat exposure test, and that was acquired using a scanning electron microscope.

FIG. 16 is a graph representing a relation between mass and a temperature for each of the ceramic-based composite materials according to the implementation example and the comparison example 2.

FIG. 17 represents measured values of a penetrating crack ratio regarding the ceramic-based composite material produced by each of the implementation example and the comparison examples.

## DESCRIPTION OF EMBODIMENTS

The following describes an embodiment of the present invention with reference to the drawings. The same reference sign is allocated to each of the corresponding parts in the respective drawings, and duplicate description is omitted.

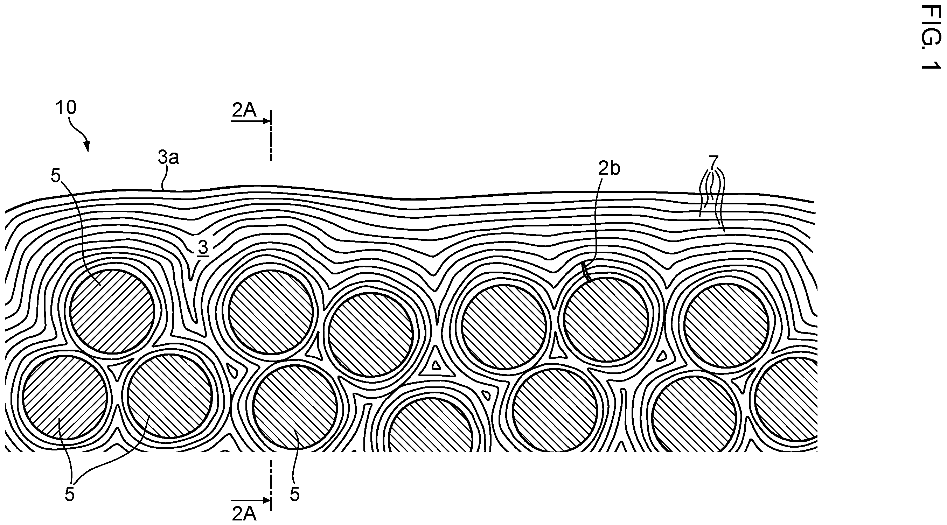

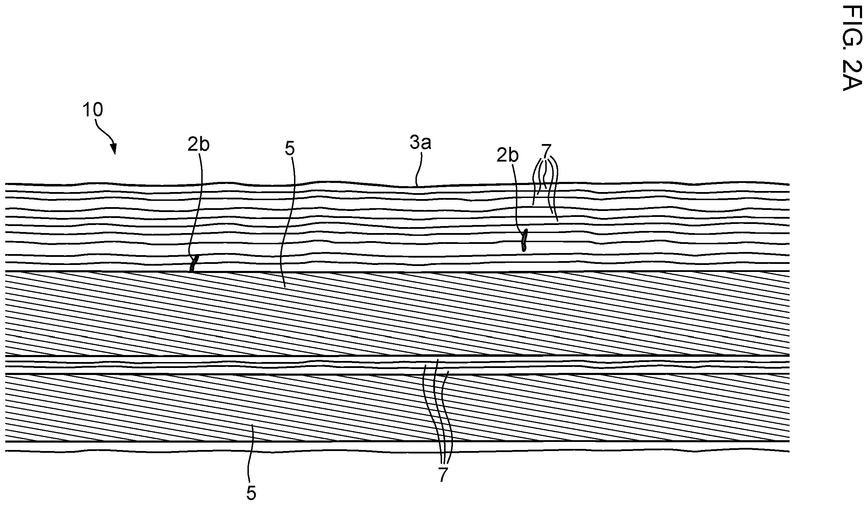

FIG. 1 is an enlarged schematic configuration diagram illustrating the vicinity of an outer surface in a cross-section of a ceramic-based composite material 10 according to an embodiment of the present invention. FIG. 2A is a 2A-2A cross-sectional view in FIG. 1. The ceramic-based composite material 10 may be used as a high-temperature structural member in a rocket engine, an aircraft jet engine, or the like. The ceramic-based composite material 10 includes a matrix 3 and reinforcing fibers 5 provided in the matrix 3.

The matrix 3 is formed of ceramic and is a base material of the ceramic-based composite material 10. The matrix 3 may be formed mainly of silicon carbide (SiC), but may be formed of different ceramic.

The reinforcing fibers 5 extend like threads, and a plurality of (e.g., a large number of) reinforcing fibers 5 are disposed in the matrix 3. For example, a fiber body formed (woven or knitted) of a large number of reinforcing fibers 5 may be disposed in the matrix 3. The reinforcing fibers 5 may be fibers of ceramic. The reinforcing fibers 5 may be carbon fibers or silicon carbide fibers, for example. Note that the reinforcing fibers 5 are not limited to these examples and may be, for example, heat-resistant oxide fibers such as alumina fibers, mullite fibers, or zirconia fibers.

As illustrated in FIG. 1 and FIG. 2A, the matrix 3 may have a layer structure where a plurality of (a large number of) layers 7 are placed on each other. The layer structure is described below.

The matrix 3 of the ceramic-based composite material 10 according to the present embodiment has a heat resistance against an assumed upper limit temperature in a use environment of the ceramic-based composite material 10, while formation of cracks is suppressed in the matrix 3 (i.e., a size and the number of cracks formed in the matrix are suppressed). The assumed upper limit temperature may be, for example, a temperature (e.g., 1400°C) in a range equal to or higher than 1400°C and equal to or lower than 1600°C, but is not limited to the temperature in this range.

Hereinafter, an example of the ceramic-based composite material 10 is described below based on penetrating cracks 2a and a penetrating crack ratio in the matrix 3. However, the ceramic-based composite material 10 according to the present embodiment (the ceramic-based composite material 10 produced using a production method described below) is not limited to a configuration described below regarding the penetrating crack ratio, and may have a configuration where formation of cracks (penetrating cracks 2a and intermediately stopped cracks 2b) are suppressed while having a heat resistance against the assumed upper limit temperature in the use environment.

The penetrating cracks 2a are cracks that reach both of an outer surface 3a of the matrix 3 and the reinforcing fibers 5. In other words, the penetrating cracks 2a are cracks that are opened to the outer surface 3a and extend from the opening to the reinforcing fibers 5 in the matrix 3. The intermediately stopped cracks 2b are cracks that do not reach both of the outer surface 3a of the matrix 3 and the reinforcing fibers 5. In other words, the intermediately stopped cracks 2b include cracks that reach only one of the outer surface 3a of the matrix 3 and the reinforcing fibers 5, and cracks that reach neither the outer surface 3a of the matrix 3 nor the reinforcing fibers 5.

For example, the ceramic-based composite material 10 may be configured such that, both before and after heating the ceramic-based composite material 10 to the assumed upper limit temperature in the use environment, the penetrating crack ratio in any section of the ceramic-based composite material 10 (hereinafter, also simply referred to as the material section) is maintained to be equal to or lower than an upper limit value. The upper limit value is equal to or lower than 0.5%, for example, but is not limited to this.

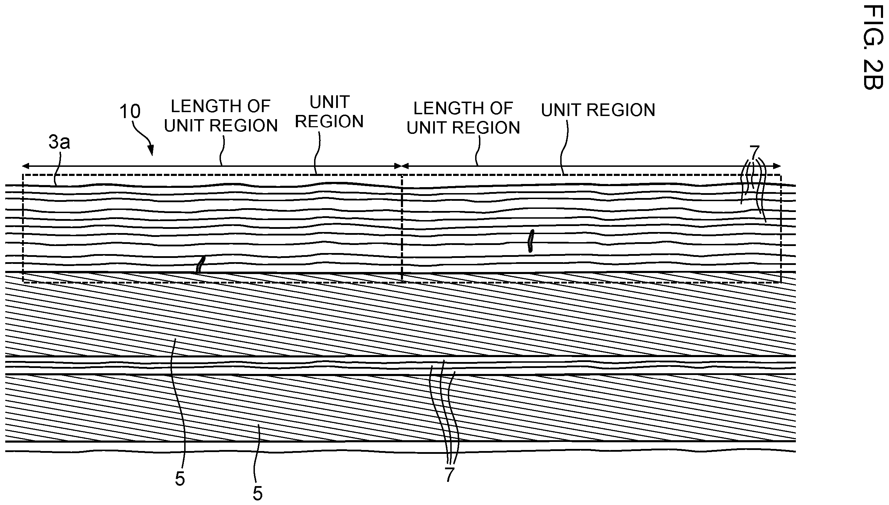

The penetrating crack ratio is a ratio of a total value of widths of the penetrating cracks 2a in any unit region (refer to FIG. 2B described below) along the outer surface 3a in the material section to a length of the unit region. In any unit region in any material section, both before and after heating the ceramic-based composite material 10 to the assumed upper limit temperature in the use environment, the upper limit value of the penetrating crack ratio of the ceramic-based composite material 10 may be equal to or lower than 0.5%, equal to or lower than 0.1%, or 0%.

When the penetrating crack 2a extends long in a direction along the outer surface 3a in the material section, a width of the penetrating crack 2a in the unit region is a width in a direction orthogonal to the material section. The material section is a section when the ceramic-based composite material 10 is cut by a plane perpendicular to the outer surface 3a.

The penetrating crack ratio can be expressed by the following expression (1). In other words, a value calculated by the expression (1) is the penetrating crack ratio (%).

$$\frac{\sum_{m=1}^{N} w_m}{L} \times 1\,0\,0 \qquad \cdots (1)$$

Here, N represents the number of the penetrating cracks 2a present in the unit region, m represents an identification number of one penetrating crack 2a, $w_m$ represents a width of the penetrating crack 2a of which identification number is m, $\Sigma$ represents the sum of $w_m$ of m = 1 to m = N, and L represents a length of the unit region in the direction along the outer surface 3a of the matrix 3.

The length of the unit region along the outer surface 3a of the matrix 3 is the length in the material section and may be a length (e.g., 300 $\mu$m or 700 $\mu$m) in a range equal to or larger 100 $\mu$m and equal to or smaller than 1000 $\mu$m, but is not limited to the length in this range.

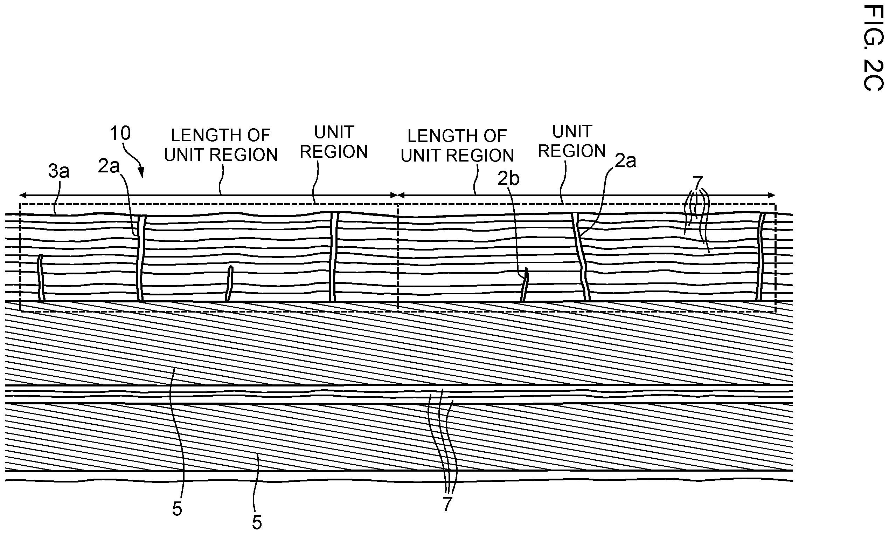

FIG. 2B illustrates the unit region in the section of FIG. 2A for the present embodiment. FIG. 2C illustrates a reference example (e.g., a comparison example 1 or 2 described below) associated with FIG. 2B. FIG. 2B and FIG. 2C illustrate two continuous unit regions (regions surrounded by the broken lines). The length (straight-line length) of the unit region along the outer surface 3a is indicated by the double arrow.

In FIG. 2B illustrating an example of the present embodiment, the penetrating cracks 2a are not present, and the penetrating crack ratio is zero.

In FIG. 2C illustrating the reference example, two penetrating cracks 2a are present in each of the unit regions. Accordingly, the expression (1) of the penetrating crack ratio specified above becomes the following expression (2).

$$\frac{w_1 + w_2}{L} \times 1\,0\,0 \qquad \cdots (2)$$

Here, $w_1$ represents a width (a dimension in the left-right direction of FIG. 2C) of one of the penetrating cracks 2a in the unit region, and $w_2$ represents a width (a dimension in the left-right direction of FIG. 2C) of the other of the penetrating cracks 2a in the unit region. In the reference example, the penetrating crack ratio is larger than 1%, for example.

As illustrated in FIG. 1 and FIG. 2A, the matrix 3 may have a layer structure where a plurality of (a large number of) layers 7 are placed on each other. In this case, the entirety of the matrix 3 may have the layer structure. That is, the entirety of the matrix 3 may be formed of a large number of layers 7 placed on each other. Alternatively, in the matrix 3, a region having the layer structure (e.g., a region from the outer surface 3a to the reinforcing fibers 5) and a region without the layer structure (e.g., a region between some reinforcing fibers 5 adjacent to each other) may be present. For example, in the production method described below, the region without the layer structure is a region where a deposition speed of ceramic (the matrix 3) is excessively fast due to influence of a concentration of thermally decomposed gas, a temperature condition, and the like. A thickness of each of the layers 7 of the layer structure may be equal to or larger than 1 μm and equal to or smaller than 10 μm, or may be equal to or larger than 2 μm and equal to or smaller than 8 μm, but is not limited to a thickness in these ranges.

In the layer structure, for example, for each of the reinforcing fibers 5, a plurality of layers 7 corresponding to the reinforcing fiber 5 may be formed around the reinforcing fiber 5 to cover the reinforcing fiber 5. In this manner, regarding each of the reinforcing fibers 5, in a cross-section of the reinforcing fiber 5, a plurality of (a large number of) layers 7 are placed on each other in order from a side of an outer peripheral surface of the reinforcing fiber 5 to surround the outer peripheral surface. In this case, in a portion where the layer 7 (or a sublayer 7a, 7b, or 7c described below) formed around an arbitrary reinforcing fiber 5 contacts with the layer 7 (or a sublayer 7a, 7b, or 7c described below) formed around another reinforcing fiber 5 or around a plurality of the reinforcing fibers 5, these layers 7 (or the sublayer 7a, 7b, or 7c) in contact with each other are formed to constitute one common layer (or one common sublayer) surrounding these reinforcing fibers 5. Each of the layers 7 that is positioned inside of the common layer 7 and that is not the common layer 7 may be formed to surround only one corresponding reinforcing fiber 5. A plurality of or a large number of the common layers 7 may be formed.

The layer structure of the matrix 3 may have the following characteristics (A) to (C).

(A) An elastic modulus of the matrix 3 at a boundary between the layers 7 adjacent to each other changes sharply (e.g., discontinuously). In other words, in the layers 7 adjacent to each other, an elastic modulus of the matrix 3 changes sharply when a position is shifted from one of the two layers 7 to the other of the two layers 7. Regarding each pair of the layers 7 adjacent to each other, an elastic modulus of the matrix 3 may change sharply at the boundary between the layers 7.

(B) At the boundary between the layers 7 adjacent to each other, a degree of crystallinity of the matrix 3 changes sharply (e.g., discontinuously). In other words, in the layers 7 adjacent to each other, a degree of crystallinity of the matrix 3 changes sharply when a position is shifted from one of the two layers 7 to the other of the two layers 7. Regarding each pair of the layers 7 adjacent to each other, a degree of crystallinity of the matrix 3 may change sharply at the boundary between the layers 7. A degree of crystallinity may be a ratio of a volume occupied by crystals in the layer to a total volume of the layer 7, a crystal grain size (e.g., an average crystal grain size) in the layer 7, or a degree of crystallinity in consideration of both of the factors. A degree of crystallinity in consideration of both of the factors may be the sum of a value obtained by multiplying the above-described ratio of the volume by a predetermined coefficient k1 and a value obtained by multiplying the above-described crystal grain size by a predetermined coefficient k2.

(C) At the boundary between the layers 7 adjacent to each other, a composition of the matrix 3 changes sharply (e.g., discontinuously). In other words, in the layers 7 adjacent to each other, a composition of the matrix 3 changes sharply when a position is shifted from one of the two layers 7 to the other of the two layers 7. Regarding each pair of the layers 7 adjacent to each other, a composition of the matrix 3 may change sharply at the boundary between the layers 7. Here, the composition may be a ratio between the numbers of atoms of a plurality of main elements (e.g., two specific elements) forming the matrix 3. When the matrix 3 is formed of mainly silicon carbide, the above-described composition may be a ratio of the number of carbon atoms to the number of silicon atoms. In other words, the above-described composition may be the ratio (hereinafter, referred to as C/Si ratio) of the number of C atoms to the number of Si atoms.

When the matrix 3 is formed mainly of silicon carbide, the matrix 3 may include carbon C that does not form silicon carbide and that exists at a position (e.g., at a grain boundary) between two crystal grains adjacent to each other, or the matrix 3 may may include SiC having a distorted crystal structure in which the number of atoms of carbon C is larger. In this case, for example, the C/Si ratio is more than 1, and all atoms of silicon Si in the matrix 3 may form silicon carbide.

The above-described characteristic (A) may result from the above-described characteristic (B), and the above-described characteristic (B) may result from the above-described characteristic (C). For example, the layer 7 having a relatively higher degree of crystallinity may be the layer 7 having a relatively higher elastic modulus, and the layer 7 having a relatively lower degree of crystallinity may be the layer 7 having a relatively lower elastic modulus. The above-described C/Si ratio may represent a degree of crystallinity and an elastic modulus. In this case, a lower C/Si ratio represents a higher degree of crystallinity, and thus represents a higher elastic modulus. Accordingly, as a C/Si ratio of the layer 7 decreases, a ratio of crystals increases or a crystal grain size increases. Thus, the layer 7 has a higher degree of crystallinity and a higher elastic modulus. Meanwhile, when a C/Si ratio of the layer 7 increases, a ratio of carbon C increases. Thus, the layer 7 is relatively substantially amorphous or has a smaller crystal grain size such that the elastic modulus is lower.

The layer structure of the matrix 3 does not need to have all of the above-described characteristics (A) to (C), and may have any one or two of the characteristics (A) to (C). For example, at a boundary between the layers 7 adjacent to each other, an elastic modulus of the matrix 3 only needs to change, and either or both of a degree of crystallinity and a composition of the matrix 3 does not need to change. Concerning the above-described characteristic (A), (B), or (C), an elastic modulus, a degree of crystallinity, or a composition of the matrix 3 only needs to change at a boundary between the layers 7 adjacent to each other, and does not need to change sharply as described above.

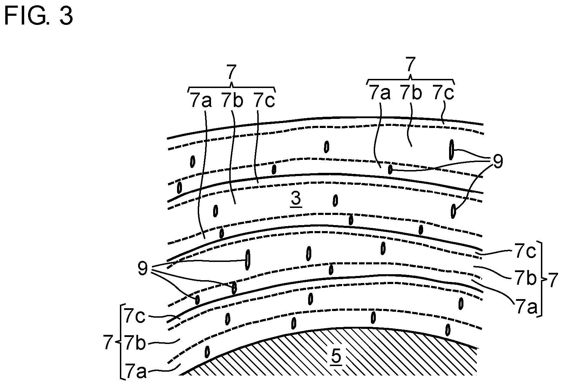

FIG. 3 corresponds to a partially enlarged view of FIG. 1. As illustrated in FIG. 3, the respective layers 7 or some of the layers 7 in the matrix 3 may each include a plurality of sublayers 7a, 7b, and 7c in this order from a side closer to the reinforcing fiber 5 associated with the layer 7. In FIG. 3, a boundary between the sublayers adjacent to each other is indicated by the broken line, and a boundary between the layers 7 adjacent to each other is indicated by the solid line. Each of the layers 7 including a plurality of the sublayers may have the following characteristics (a) to (c). In the case of the above-described characteristic (A), the layer 7 may have the following characteristic (a). In the case of the above-described characteristic (B), the layer 7 may have the following characteristic (b). In the case of the above-described characteristic (C), the layer 7 may have the following characteristic (c).

(a) A plurality of (in the example of FIG. 3, three) sublayers 7a, 7b, and 7c constituting the layer 7 may have mutually different values of the above-described elastic modulus, and include the sublayer 7c having a relatively higher elastic modulus and the sublayer 7a having a relatively lower elastic modulus. In this case, an elastic modulus of the sublayer 7b may have a value between the elastic modulus of the sublayer 7c and the elastic modulus of the sublayer 7a. Regarding a plurality of the sublayers 7a, 7b, and 7c, an elastic modulus of the matrix 3 may change sharply (e.g., discontinuously) at a boundary between the sublayers adjacent to each other. An elastic modulus of the matrix 3 may be substantially uniform in each of the sublayers 7a, 7b, and 7c. In the layer 7, the sublayer more separated from the associated reinforcing fiber 5 may have a larger elastic modulus.

(b) A plurality of (in the example of FIG. 3, three) sublayers 7a, 7b, and 7c constituting the layer 7 may have mutually different values of the above-described degree of crystallinity, and include the sublayer 7c having a relatively higher degree of crystallinity and the sublayer 7a having a relatively lower degree of crystallinity. In this case, a degree of crystallinity of the sublayer 7b may have a value between the degree of crystallinity of the sublayer 7c and the degree of crystallinity of the sublayer 7a. Regarding a plurality of the sublayers 7a, 7b, and 7c, a degree of crystallinity of the matrix 3 may change sharply (e.g., discontinuously) at a boundary between the sublayers adjacent to each other. A degree of crystallinity of the matrix 3 may be substantially uniform in each of the sublayers 7a, 7b, and 7c. In the layer 7, the sublayer more separated from the associated reinforcing fiber 5 may have a higher degree of crystallinity.

(c) A plurality of (in the example of FIG. 3, three) sublayers 7a, 7b, and 7c constituting the layer 7 may have mutually different values of the above-described ratio (the above-described composition) between the numbers of atoms, and include the sublayer 7c or 7a having a relatively higher ratio between the numbers of atoms and the sublayer 7a or 7c having a relatively lower ratio between the numbers of atoms. In this case, a ratio of the sublayer 7b may have a value between the ratio of the sublayer 7c and the ratio of the sublayer 7a. Regarding a plurality of the sublayers 7a, 7b, and 7c, the ratio of the matrix 3 may change sharply (e.g., discontinuously) at a boundary between the sublayers adjacent to each other. The ratio of the matrix 3 may be substantially uniform in each of the sublayers 7a, 7b, and 7c. When the matrix 3 is formed mainly of silicon carbide, in the layer 7, the sublayer more separated from the associated reinforcing fiber 5 may have a lower C/Si ratio.

The above-described characteristic (a) may result from the above-described characteristic (b), and the above-described characteristic (b) may result from the above-described characteristic (c). For example, the sublayer having a relatively higher degree of crystallinity may be the sublayer having a relatively higher elastic modulus, and the sublayer having a relatively lower degree of crystallinity may be the sublayer having a relatively lower elastic modulus. The layer 7 does not need to have all of the above-described characteristics (a) to (c), and may have any one or two of the above-described characteristics of (a) to (c). For example, at a boundary between the sublayers adjacent to each other, an elastic modulus of the matrix 3 only needs to change, and either or both of a degree of crystallinity and a composition of the matrix 3 does not need to change. Particularly, the sublayers that belong to the layers 7 adjacent to each other and that are adjacent to each other across the boundary between the two layers 7 may have mutually different values of at least an elastic modulus among an elastic modulus, a degree of crystallinity, and a composition. The sublayers adjacent to each other in one layer 7 may have mutually different values of at least an elastic modulus among an elastic modulus, a degree of crystallinity, and a composition. Concerning the above-described characteristic (a), (b), or (c), an elastic modulus, a degree of crystallinity, or a composition of the matrix 3 only needs to change at the boundary between the sublayers adjacent to each other, and does not need to change sharply as described above.

The number of the sublayers present in one layer 7 can depend on a condition (e.g., a temperature rising rate described below or a first target temperature described below) at the time of forming the matrix 3. Thus, the number of the sublayers is not limited to three and may be two or may be four or more. The layer where boundaries between the sublayers 7a, 7b, and 7c are not clear may be present. In this case, in one layer 7, two sublayers may be present, or no sublayers may be present.

A thickness of each of the sublayers 7a, 7b, and 7c may be equal to or larger than 0.1 $\mu$m and equal to or smaller than 10.0 $\mu$m, may be equal to or larger than 0.3 $\mu$m and equal to or smaller than 10.0 $\mu$m, or may be equal to or larger than 0.3 $\mu$m and equal to or smaller than 8.0 $\mu$m, and may be a value in another numerical range.

The matrix 3 may include a plurality of (a large number of) fine closed pores 9 formed inside matrix 3 so as not to be opened to the outer surface 3a. Each of the closed pores 9 is a void that is closed by the matrix 3. Each of the closed pores 9 may have a dimension such that the closed pore 9 can be included in one layer 7 or in the sublayer 7a, 7b, or 7c. For example, a dimension (the maximum dimension among dimensions in respective directions) of each of the closed pores 9 may be a value in a range equal to or larger than 2 $\mu$m and equal to or smaller than 8 $\mu$m. The closed pore 9 having a dimension that does not belong to this range may be present in the matrix 3.

(Method for Producing Ceramic-Based Composite Material)

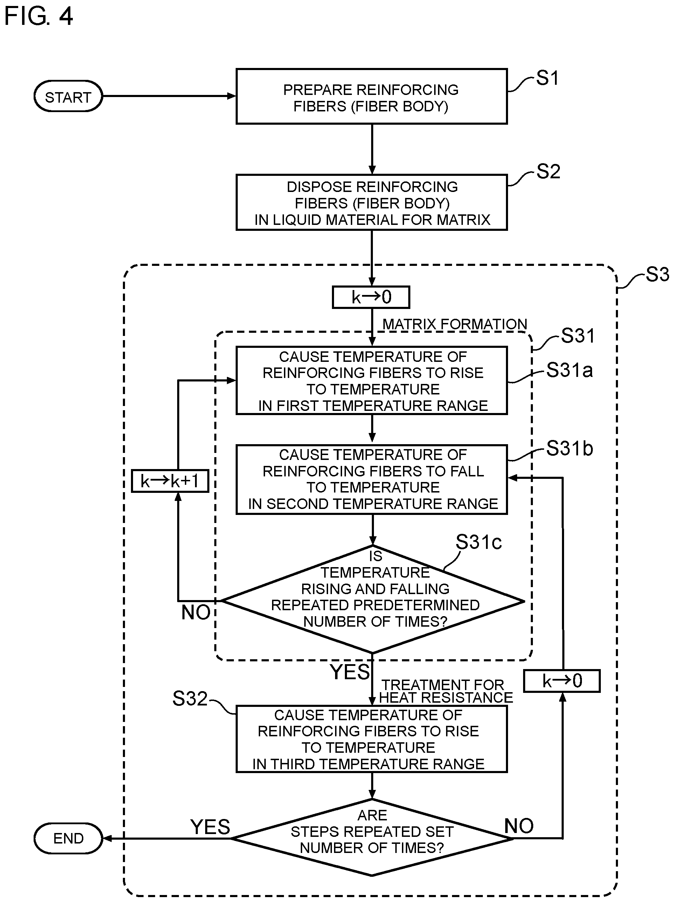

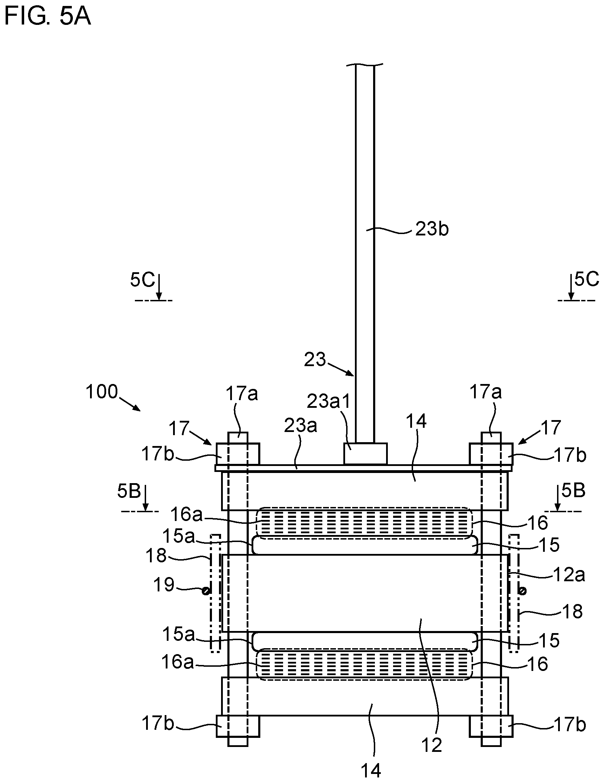

FIG. 4 is a flowchart illustrating a method for producing the ceramic-based composite material 10 according to the embodiment of the present invention. FIG. 5A illustrates a configuration example of an attachment tool 100 that can be used in the production method. With the production method according to the present embodiment, the ceramic-based composite material 10 according to the above-described embodiment can be fabricated. This production method includes the steps S1 to S3.

<Step S1>

At the step S1, a plurality of (a large number of) reinforcing fibers 5 are prepared. For example, a fiber body formed (woven or knitted) of a large number of reinforcing fibers 5 is prepared. The fiber body may have a three-dimensional shape. The reinforcing fibers 5 prepared at the step S1 may be carbon fibers or silicon carbide fibers, for example, but are not limited to these as described above.

<Step S2>

At the step S2, a plurality of reinforcing fibers 5 (e.g., the above-described fiber body) prepared at the step S1 are disposed in a liquid material for the matrix 3. This liquid material is a liquid that is a material for the matrix 3. When the matrix 3 is formed mainly of silicon carbide, the liquid material may be a liquid material (LPCS: liquid polycarbosilane) of silicon carbide, for example.

Attachment Tool

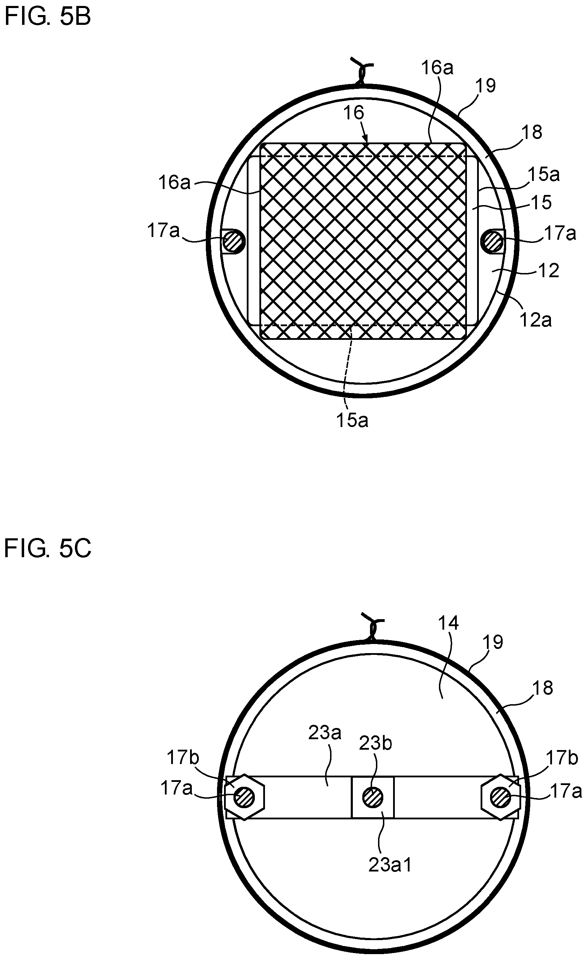

The step S2 may be performed using the attachment tool 100 illustrated in FIG. 5A. FIG. 5B is a 5B-5B arrow view in FIG. 5A. The attachment tool 100 includes a heated body 12, a pair of heat insulating plates 14, a porous body 16, an acting mechanism 17, a heat insulating member 18, and a suspension unit 23.

The heated body 12 is induction-heated. The heated body 12 is formed of graphite, for example.

A pair of the heat insulating plates 14 are disposed such that the heated body 12 is interposed between the heat insulating plates 14. The heat insulating plates 14 are each formed of a material (e.g., alumina) having a heat insulating property. The heat insulating plates 14 each have a plate shape. The heat insulating plates 14 and the heated body 12 may have, for example, circular shapes having the same radius when seen from a thickness direction of the heat insulating plates 14.

The porous body 16 is disposed between the heated body 12 and the heat insulating plate 14. The porous body 16 includes a large number of pores through which fluid can pass. For example, the porous body 16 may include a plurality of wire nets superimposed on each other. As illustrated in FIG. 5A, the attachment tool 100 may include two porous bodies 16. In other words, the porous body 16 may be disposed between the heated body 12 and one of the heat insulating plates 14 and between the heated body 12 and the other of the heat insulating plates 14.

In a state where the fiber body 15 is disposed between the heated body 12 and the porous body 16, the acting mechanism 17 applies force of holding the heated body 12, the porous body 16, and the fiber body 15 between a pair of the heat insulating plates 14. As a result, the fiber body 15 is held by the attachment tool 100 while being in contact with the heated body 12 and the porous body 16. When two porous bodies 16 are provided, in a state where the fiber body 15 is disposed between the heated body 12 and one of the porous bodies 16 and between the heated body 12 and the other of the porous bodies 16, the acting mechanism 17 applies force of holding the heated body 12, the two porous bodies 16, and the two fiber bodies 15 between a pair of the heat insulating plates 14. As a result, each of the fiber bodies 15 is held by the attachment tool 100 while being in contact with the heated body 12 and the associated porous body 16.

The acting mechanism 17 includes a bolt 17a and a nut 17b, for example. The bolt 17a penetrates through the two heat insulating plates 14 and the heated body 12 such that a gap exists between the bolt 17a and each of the heat insulating plates 14 and the heated body 12. The nuts 17b are screwed onto both end portions of each of the bolts 17a. By fastening the nuts 17b to the bolts 17a in a direction in which the two heat insulating plates 14 approach each other, the porous body 16, the heated body 12, and the fiber body 15 are held between a pair of the heat insulating plates 14. The bolt 17a may be formed of a material (e.g., alumina) that is not induction-heated. A plurality of (in the example of FIG. 5A, two) acting mechanisms 17 may be provided.

The heat insulating member 18 covers outer peripheries 12a and 15a of the heated body 12 and the fiber body 15 (in the example of FIG. 5A, two fiber bodies 15). In other words, the heated body 12 and the fiber body 15 include the outer peripheries 12a and 15a, respectively, that surround a central axis oriented in the thickness direction of the heat insulating plates 14, and these outer peripheries 12a and 15a are covered with the heat insulating member 18 as illustrated in FIG. 5B. In FIG. 5A, only parts of the heat insulating member 18 positioned on both sides (left and right sides in the drawing) of the heated body 12 and the fiber body 15 are depicted by the two-dot chain lines. The heat insulating member 18 is formed of a material having a heat insulating property. For example, the heat insulating member 18 may be heat-insulating cloth (fabric) formed of glass. To fix the heat insulating member 18 to the heated body 12, in the examples of FIG. 5A and FIG. 5B, a wire 19 may be wound around the heat insulating member 18 from the outside thereof. However, the heat insulating member 18 may be fixed using other means.

In a state where the fiber body 15 is attached to the attachment tool 100 (hereinafter, simply referred to as an attached state), as illustrated in FIG. 5A, the heated body 12, the fiber body 15 (two fiber bodies 15) and the porous body 16 (two porous bodies 16) are interposed between a pair of the heat insulating plates 14, and the heat insulating member 18 covers the outer peripheries 12a and 15a of the heated body 12 and the fiber bodies 15 as described above. In this attached state, each of the porous bodies 16 is exposed to an outer peripheral side. In other words, each of the porous bodies 16 includes an outer periphery 16a that surrounds the central axis oriented in the thickness direction of the heat insulating plates 14, and the outer peripheries 16a are exposed to an outside in the radial direction with respect to the central axis. In the attached state, in the example of FIG. 5A, the fiber bodies 15 contact with the heated body 12, but do not need to contact with the heated body 12.

The suspension unit 23 suspends the fiber bodies 15 and the heated body 12 at the step 2. FIG. 5C is a 5C-5C arrow view in FIG. 5A. The suspension unit 23 includes a plate-shaped member 23a and a rod-shaped member 23b. The plate-shaped member 23a is elongated, in the left-right direction in FIG. 5A and FIG. 5C, along an upper surface of the upper-side heat insulating plate 14. The bolts 17a penetrates through both end portions of the plate-shaped member 23a such that a gap exists between the plate-shaped member 23a and each of the bolts 17a. Each of both end portions of the plate-shaped member 23a are each interposed between the upper-side heat insulating plate 14 and the upper-side nut 17b. A coupling portion 23a1 is provided at a central portion of the plate-shaped member 23a. The rod-shaped member 23b is coupled to the coupling portion 23a1. The rod-shaped member 23b extends upward from the coupling portion 23a1. For example, although not illustrated in the drawing, a protrusion may be provided as a bolt on an upper surface of the coupling portion 23a1, and a bolt hole may be formed on a lower end surface of the rod-shaped member 23b. In this case, by screwing the bolt into the bolt hole, the coupling portion 23a1 and the rod-shaped member 23b are coupled to each other.

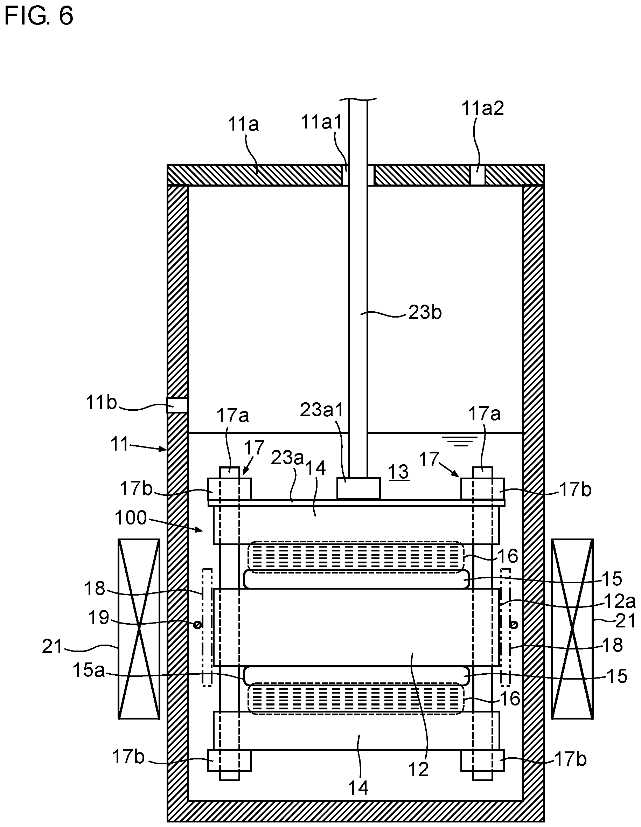

At the step S2, in the above-described attached state, the fiber bodies 15 are disposed in a treatment vessel 11 together with the attachment tool 100 as illustrated in FIG. 6. As a result, the entirety of the fiber bodies 15 is positioned in a liquid material 13 held in the treatment vessel 11. At this time, the fiber bodies 15 and the heated body 12 are suspended by the suspension unit 23 such that the attachment tool 100, the heated body 12, and the fiber bodies 15 do not contact with an inner surface (a bottom surface and an inner peripheral surface) of the treatment vessel 11. In addition, at this time, the rod-shaped member 23b of the suspension unit 23 may be disposed to penetrate through a penetration hole 11a1 of a cover member 11a that closes an opening of an upper surface of the treatment vessel 11. An upper-end-side portion of the rod-shaped member 23b may be coupled to an unillustrated structure by appropriate means so as to be supported by the structure.

At the step S2, the above-described suspension unit is not limited to the configuration examples illustrated in FIG. 5A, FIG. 5C, and the like as long as the above-described suspension unit can suspend the fiber body 15 and the heated body 12 such that the attachment tool 100, the heated body 12, and the fiber body 15 do not contact with the inner surface of the treatment vessel 11 (i.e., are separated from the inner surface of the treatment vessel). Each of the heat insulating plates 14 may be omitted in the attachment tool.

The treatment vessel 11 is formed of a non-electroconductive material (e.g., glass) that cannot be induction-heated. The treatment vessel 11 may include a gas introduction hole 11b formed for introducing nitrogen gas into a gas phase portion in the treatment vessel 11 at the step S3 described below, and a gas discharge hole 11a2 formed for discharging gas from the gas phase portion in the treatment vessel 11 at the step S3.

<Step S3>

At the step S3, the matrix 3 is formed by film boiling (FB). In other words, in a state where a plurality of the reinforcing fibers 5 (e.g., the above-described fiber bodies 15) are disposed in the liquid material 13 at the step S2, each of the reinforcing fibers 5 and the liquid material 13 are heated. Due to this heating, ceramic derived from the liquid material 13 is deposited as the matrix 3 on each of the reinforcing fibers 5 to form the matrix 3. In other words, the liquid material 13 is heated by the heated reinforcing fibers 5 to turns into a film-boiling gas at an interface between the reinforcing fiber 5 and the liquid material 13. The film-boiling gas causes the ceramic (i.e., thermally decomposed precipitates as the ceramic) to be generated and deposited on each of the reinforcing fibers 5. The ceramic generated on each of the reinforcing fibers 5 may result from one or both of the following events (1) and (2).

(1) The film-boiling gas collides with the heated reinforcing fibers 5, and thus, further receives thermal energy. Thereby, the film-boiling gas proceeds to be thermally decomposed and become inorganic, resulting in the solid ceramic precipitated on the heated reinforcing fibers 5.
(2) A gas included in a part of the film-boiling gas has already been thermally decomposed. This thermally decomposed gas collides with the heated reinforcing fibers 5, and thereby proceeds to become inorganic, resulting in the solid ceramic precipitated on the heated reinforcing fibers 5.

At the above-described step S3, rising and falling of a heating temperature of the reinforcing fibers 5 (fiber body 15) may be repeated. As a result, the above-described layer structure is formed. In other words, at the step S3, depending on the repetition of the rising and the falling of a temperature of the reinforcing fibers 5, an elastic modulus, a degree of crystallinity, a composition, and the like change in the process of depositing the ceramic, and thus the layer structure of the matrix 3 is formed. At the step S31a or S32 described below, when a temperature rises, a ratio of the thermally decomposed gas in the film-boiling gas increases. As a result, it is considered that a composition of the matrix 3 changes (e.g., the C/Si ratio decreases).

The step S3 includes a step S31 and a step S32.

At the step S31, the reinforcing fibers 5 in the liquid material 13 are heated such that a temperature of the reinforcing fibers 5 becomes a matrix forming temperature. The matrix forming temperature is a temperature at which the matrix is deposited on the reinforcing fibers 5 (fiber body 15). The matrix forming temperature may be a temperature in a first temperature range described below. At the step S31, the ceramic as the matrix 3 is precipitated and deposited on the reinforcing fibers 5 to form the matrix 3 on the reinforcing fibers 5.

At the step S32, the reinforcing fibers 5 in the liquid material 13 are heated such that a temperature of the reinforcing fibers 5 becomes a heat resistance imparting temperature. The heat resistance imparting temperature is a temperature higher than the matrix forming temperature. The heat resistance imparting temperature may be an assumed upper limit temperature in a use environment temperature of the ceramic-based composite material 10. As a result of the step S32, the matrix 3 formed at the previous step S31 comes to have a heat resistance at the heat resistance imparting temperature (assumed upper limit temperature).

The step S31 and the step S32 are repeatedly performed in this order. As a result, the formation of the matrix 3 and the imparting of a heat resistance to the matrix 3 are repeatedly performed. In other words, while repeatedly forming the new matrix 3 at the step S31, a heat resistance is imparted to the new matrix 3 each time the new matrix 3 is formed.

The step S31 includes Steps S31a to S31c.

At the step S31a, a temperature of the reinforcing fibers 5 is caused to rise so as to reach a temperature in the first temperature range in which the matrix 3 is deposited to the reinforcing fibers 5. As a result, the ceramic as the matrix 3 is precipitated on the reinforcing fibers 5. In other words, the matrix 3 is deposited and formed on the reinforcing fibers 5.

A temperature of the reinforcing fibers 5 may refer to a temperature of the reinforcing fibers 5 themselves or may refer to a temperature of the heated body 12 in contact with the reinforcing fibers 5 (the same applies to the following). By causing a temperature of the reinforcing fibers 5 to be a temperature in the first temperature range, the matrix 3 is deposited to the reinforcing fibers 5 as described above. The lower limit of the first temperature range may be equal to or higher than a temperature at which the deposition of the matrix 3 on the reinforcing fibers 5 starts.

At the step S31a, for example, the heated body 12 is induction-heated by an alternating magnetic field that is generated from a coil 21 by causing an alternating current to flow through the coil 21 as illustrated in FIG. 6. As a result, a temperature of the reinforcing fibers 5 rises. Each of the fiber bodies 15 and the liquid material 13 are heated by heat generated from the induction-heated heated body 12.

The step S31b may be performed after the step S31a. For example, at the step S31a, when a temperature of the fiber body 15 (reinforcing fibers 5) reaches the first target temperature in the first temperature range, the process proceeds to the step S32. For example, when a temperature measured by a temperature sensor attached to the surface of the heated body 12 reaches the first target temperature, the process proceeds to the step S31b. The first target temperature only needs to be a temperature in the first temperature range, and may be constant or changed in the course of repeating the step S31a a plurality of times as described below.

At the step S31b, a temperature of the reinforcing fibers 5 is caused to fall so as to reach a temperature in a second temperature range in which the matrix 3 is not deposited to the reinforcing fibers 5. As a result, the deposition of the matrix 3 on the reinforcing fibers 5 is stopped.

An upper limit of the second temperature range is lower than the lower limit of the first temperature range. When a temperature of the reinforcing fibers 5 falls from a temperature in the first temperature range, the upper limit of the second temperature range may be equal to or lower than a temperature at which the deposition of the matrix 3 on the reinforcing fibers 5 is stopped. In this case, a lower limit of the second temperature range may be equal to or higher than a boiling point of the liquid material 13, or an upper limit of the second temperature range may be lower than the boiling point of the liquid material.

At the step S31b, for example, the heating of the reinforcing fibers 5 is stopped, and the state where the heating of the reinforcing fibers 5 is stopped is maintained until a temperature of the reinforcing fibers 5 reaches a second target temperature in the second temperature range. The second target temperature only needs to be a temperature in the second temperature range, and may be constant or changed in the course of repeating the step S31b a plurality of times as described below.

At the step S31b, while stopping the heating of the reinforcing fibers 5, an inside of the treatment vessel 11 may be cooled. For example, the liquid material 13 may be circulated such that a part of the liquid material 13 in the treatment vessel 11 is caused to flow to an outside of the treatment vessel 11 such that the liquid material 13 is cooled by a heat exchanger, and the cooled liquid material 13 subsequently returns to the treatment vessel 11. In this case, a pipe or a pump (not illustrated) for circulating the liquid material 13 as described above may be provided.

When the step S31b is completed (e.g., when a temperature of the reinforcing fibers 5 reaches the second target temperature), the next step S31a or S32 is performed via the determination of the step S31c.

At the step S31c, in a case where the number k of times the step S31a and the step S31b have been repeated is a predetermined number N of times (in a case where the step S31a has been performed the predetermined number N of time N) when the previous step S31b is completed, the process proceeds to the step S32. Otherwise, the process returns to the step S31a, and the steps S31a to S31c are performed again.

The predetermined number N of times may be two, or may be equal to or larger than three. For example, the predetermined number N of times may be equal to or larger than two and equal to or smaller than five. The number k of times determined at the step S31c is zero when the process proceeds from the step S2 to the step S31a, is incremented by one when the process returns from the step S31c to the step S31a, and returns to zero when the process returns from the step S32 to the step S31 (step S31b) as described below. The number N of times may be changed when the process proceeds from the step S31c to the step S32, or may be fixed over the step S3.

At the step S32, a temperature of the reinforcing fibers 5 is caused to rise so as to reach a temperature in a third temperature range in which a heat resistance is imparted to the matrix 3. The third temperature range is higher than the first temperature range. In other words, a lower limit of the third temperature range is a temperature higher than the upper limit of the first temperature range. The lower limit of the third temperature range may be the upper limit (the above-described assumed upper limit temperature) assumed in the environment where the ceramic-based composite material 10 produced by the production method is used. By setting a temperature of the reinforcing fibers 5 to a temperature in the third temperature range, the reinforcing fibers 5 are heated such that a temperature of the reinforcing fibers 5 becomes equal to or higher than the assumed upper limit temperature at the step S32.

At the step S32, as in the above-described step 31, the heated body 12 may be induction-heated by an alternating magnetic field generated from the coil 21 by causing an alternating current to flow through the coil 21. As a result, a temperature of the reinforcing fibers 5 rises.

After the step S32 is completed, when the step S31 and the step S32 have not been repeated a set number of times, the process returns to the step S31 (e.g., the step S31b). For example, when a temperature of the fiber body 15 (reinforcing fibers 5) reaches a third target temperature in the third temperature range at the step S32, the process may return to the step S31 (e.g., the step S31b). The third target temperature only needs to be a temperature in the third temperature range, and may be constant or changed in the course of repeating the step S32 a plurality of times.

Repeating the step S31 and the step S32 the set number of times (the set number of a plurality of times) as described above produces the ceramic-based composite material 10. In other words, repeating the step S31 and the step S32 causes the ceramic to be deposited around each of the reinforcing fibers 5 in order such that the ceramic is gradually formed as the matrix 3. Accordingly, for example, the step S31 and the step S32 may be repeated until a thickness of the matrix 3 reaches a desired thickness. The above-described set number of times is, for example, a value in a range equal to or larger than 3 and equal to or smaller than 30, but is not limited to this range. In the present embodiment, at the step S3, the step S32 may be performed last, as illustrated in in FIG. 4.

Performing the step S31a or the step S32 one time causes one layer 7 to be formed on each of the reinforcing fibers 5 such that the above-described film-boiling gas results in the ceramic as the one layer 7 deposited to each of the reinforcing fibers 5.

When the matrix 3 is formed mainly of silicon carbide, for example, the above-described first temperature range is a range equal to or higher than 800°C and equal to or lower than 1200°C, the above-described second temperature range is a range equal to or higher than 200°C and equal to or lower than 600°C, and the above-described third temperature range is a range equal to or higher than 1300°C (or equal to or higher than 1400°C) and equal to or lower than 1600°C. However, the first temperature range, the second temperature range, and the third temperature range may be other ranges, respectively.

The first temperature range, the second temperature range, and the third temperature range described above may be determined depending on the kind of the liquid material 13 or the above-described assumed upper limit temperature. The upper limit level of the first temperature range may be lower than the lower limit level of the third temperature range. For example, a difference between the upper limit of the first temperature range and the lower limit of the third temperature range may be 100°C or higher, 200°C or higher, or 300°C or higher.

When the matrix 3 is formed mainly of silicon carbide, at the step S31a and the step S32, a temperature rising rate of the reinforcing fibers 5 (or the heated body 12) may be equal to or higher than 1000°C/hour. In this case, the temperature rising rate may be equal to or lower than 3000°C/hour, or may be higher than 3000°C/hour. However, the temperature rising rate may be a different value.

Not only when the matrix 3 is formed mainly of silicon carbide but also when the matrix 3 is formed of another material, a temperature rising rate at the step S31a (or each of the step S31a and the step S32) is low enough that a plurality of the sublayers are formed in one layer 7 (each of the layers 7). For example, the temperature rising rate may be equal to or lower than 3000°C/hour, be equal to or lower than 2000°C/hour, or be equal to or lower than 1500°C/hour. In this case, the temperature rising rate may be equal to or higher than 1000°C/hour (or be higher than 1000°C/hour).

In other words from another viewpoint, the fiber body 15 may be heated in an appropriate period of time to form the layer structure of the matrix 3 (e.g., a plurality of the sublayers in one layer 7). For example, at the step S31a of one time (or at each of the step S31a of one time and the step S32 of one time), a period of time in which the fiber body 15 is heated (i.e., a total period of time in which the fiber body 15 is heated) is longer than 10 minutes, and may be equal to or longer than 15 minutes, be equal to or longer than 20 minutes, or be equal to or longer than 30 minutes. In this case, for example, the period of time in which the fiber body 15 is heated may be equal to or shorter than 40 minutes, be equal to or shorter than 50 minutes, or be equal to or shorter than 60 minutes, but is not limited to these ranges. The period of time may be longer than 60 minutes.

At the Step S3, the layer 7 formed of the above-described ceramic progresses in a composition change (crystallization) due to heat, and shrinks in a volume. Amounts of the volume shrinkage of the sublayers 7a, 7b, and 7c differ from each other. When the matrix 3 is formed mainly of silicon carbide, for example, the sublayer 7a transitions to an inorganic state from a semi-inorganic state close to an organic state to have the C/Si ratio that increases as an amount of the volume shrinkage increases. The difference in an amount of the volume shrinkage causes a tensile stress to act on the sublayer 7a and 7b having the larger amounts of the volume shrinkage, and causes a compressive stress to act on the sublayer 7c having the smaller amount of the volume shrinkage. Due to the tensile stress, the fine closed pores 9 are formed in the matrix 3. The above-described tensile stress is generated in a state where each of the sublayers 7a, 7b, and 7c is formed of the ceramic. Thus, in most cases, the closed pores 9 are formed as closed voids particularly in the sublayer 7a and 7b.

(Advantageous Effects of Embodiment)

In the production method according to the above-described embodiment, at the step S31, the matrix 3 is formed on the reinforcing fibers 5 by heating the reinforcing fibers 5 in the liquid material 13 such that a temperature of the reinforcing fibers 5 becomes the matrix forming temperature. At the step S32, the reinforcing fibers 5 in the liquid material 13 are heated such that a temperature of the reinforcing fibers 5 becomes the heat resistance imparting temperature (e.g., the assumed upper limit temperature in the use environment of the produced ceramic-based composite material 10). As a result, the matrix 3 formed at the previous step S31 comes to have a heat resistance at the temperature. Repeating the steps S31 and S32 described above can impart a heat resistance to the matrix 3 while forming the matrix 3. Hereinafter, the above-described advantageous effect and additional advantageous effects are described below in more detail.

By increasing a treatment temperature of the film boiling to the assumed upper limit temperature at the step S32, a degree of crystallinity of the matrix 3 increases. As a result, the matrix 3 decreases in mass, and shrinks in a volume. Due to the volume shrinkage, cracks are likely to be formed. However, at the step S32, the formation of cracks caused by the high crystallization and the formation of the matrix 3 progress simultaneously, and thus the matrix 3 where cracks (the penetrating cracks 2a and the intermediately stopped cracks 2b) are not likely to be formed can be fabricated.

Even when the cracks formed at the step S32 cannot be charged with the matrix 3 formed at the step S32, the cracks are charged with the matrix 3 formed at the next step S31. Accordingly, formation of cracks in the matrix 3 can be further suppressed.

The crystallization of the matrix 3 increases at the step S32 as described above so that the high-temperature oxidation resistance and the radiation resistance can be improved.

As described above, the formation of the penetrating cracks 2a can be suppressed, and thus the formation of a path through which a gas or a liquid enters into the matrix 3 from an outside can be suppressed. As a result, the matrix has a reduced area of a surface in contact with oxygen, and thus, the high-temperature oxidation resistance is improved.

Since the formation of the entrance path of oxygen can be suppressed, the formation of a path through which oxygen can access the fiber surface from an outside can be reduced, and thus, the high-temperature oxidation resistance is improved.

A conventional method for charging a matrix void portion is melt infiltration (MI) of causing a flow of melted metal. When coming into contact with fibers, the melted metal reacts with the fibers to cause deterioration in a strength, a rigidity, a high-temperature oxidation resistance, a melting point, and a radiation resistance of the fibers.

Meanwhile, according to the present embodiment, the formation of cracks functioning as the oxygen entrance path into the matrix 3 can be suppressed as described above, and thus, the above-described deterioration of the fibers in the MI can be avoided.

Further, since the formation of the intermediately stopped cracks 2b can be suppressed, fracture origins of the matrix 3 can be reduced, and a decrease in a specific strength (the maximum stress in an elastic region where formation or progress of cracks does not occur) and the strength (breaking stress) can be suppressed.

When the step S31 includes the above-described steps S31a and S31b, the following advantageous effects can be achieved.

When the lower limit of the second temperature range is equal to or higher than the boiling point of the liquid material 13, at the step S31b, a temperature of the reinforcing fibers 5 falls to be a temperature in the second temperature range such that the boiling of the liquid material is alleviated. As a result, at the step S31b, the liquid material is likely to enter cracks formed in the matrix 3. Accordingly, in the next step S31a, the matrix 3 is likely to be formed in the cracks.

When the upper limit of the second temperature range is lower than the boiling point of the liquid material, at the step S31b, a temperature of the reinforcing fibers 5 falls to be a temperature in the second temperature range such that the boiling phenomenon of the liquid material is stopped. As a result, in a state where a new film-boiling gas is not generated any more, the previously generated film-boiling gas is replaced with the liquid material such that the liquid material is more likely to enter cracks formed in the matrix 3. Accordingly, at the next step S31a, the matrix 3 is more likely to be formed in the cracks.

In the production method according to the above-described embodiment, when the step S31 is repeated, the matrix 3 formed at the step S31 before the final step S31 is already heated at the heat resistance imparting temperature at the time of the final step S31. Accordingly, in the matrix 3 formed at the step S31 before the final step S31, cracks are not likely to be formed at the final step S32. Thus, even when cracks are formed in the matrix 3 at the final step S32, the cracks are in a range of a thin layer of the matrix 3 formed at the step S31 immediately before the final step S32.

In the ceramic-based composite material 10 produced by the production method according to the above-described embodiment, the penetrating cracks 2a are not present or are suppressed. Accordingly, an additional process for charging the penetrating cracks 2a with the matrix 3 can be omitted.

Further, in the production method according to the above-described embodiment, the process step (step S32) of imparting a heat resistance to the matrix 3 is already performed in the course of forming the matrix 3. Accordingly, an additional heat treatment for imparting a heat resistance to the matrix 3 can be omitted.

The ceramic-based composite material 10 produced by the production method according to the above-described embodiment includes the matrix 3 having the heat resistance against the assumed upper limit temperature in the use environment while formation of cracks is suppressed in the matrix 3. In one example, the ceramic-based composite material 10 before and after being heated at the assumed upper limit temperature in the use environment of the ceramic-based composite material may have the penetrating crack ratio that is equal to or lower than 0.5%, is equal to or lower than 0.1%, or is 0%. However, the present invention is not limited to this.

In the ceramic-based composite material 10 produced by the production method according to the above-described embodiment, even when the ceramic-based composite material 10 is heated at the upper limit temperature in the use environment, a decrease in weight is small as in a mass reduction in the below-described implementation example. Even from this viewpoint, it can be said that the ceramic-based composite material 10 according to the present embodiment has the high heat resistance.

With the ceramic-based composite material 10 according to the present embodiment, the following advantageous effects (i) to (iv) can also be achieved.

    (i) By the above-described step S3, the sublayer 7a having a relatively lower elastic modulus and the sublayer 7c having a relatively higher elastic modulus can be formed in each of the layers 7 of the layer structure. When the matrix 3 is formed mainly of silicon carbide, the sublayer 7a having a relatively lower elastic modulus is a sublayer having a higher C/Si ratio, and the sublayer 7c having a relatively higher elastic modulus is a sublayer having a lower C/Si ratio. The sublayer 7a having a lower elastic modulus is likely to follow deformation such as bending of the ceramic-based composite material 10. As a result, formation of cracks can be suppressed in the ceramic-based composite material 10. Meanwhile, in the sublayer 7c having a higher elastic modulus, the higher elastic modulus is maintained. Accordingly, in the layer structure of the matrix 3, the sublayer 7a having a lower elastic modulus and the sublayer 7c having a higher elastic modulus exist together so that formation of cracks can be suppressed while a higher elastic modulus can be maintained.

(ii) When a stress is generated in a material, a resistance against fracture of the material caused by progress of a crack due to the stress is represented by a fracture toughness value. As energy required for fracturing the material due to the progress of a crack increases, a fracture toughness value of the material increases. Meanwhile, in the material where a stress is generated, the generated energy is proportional to a cross-sectional area of the material. Accordingly, forming the layer structure results in a decrease in the above-described energy generated in the layer 7 having a small cross-sectional area. In other words, the matrix 3 has the layer structure in which the energy generated by the stress is dispersed to the respective layers 7 or the respective sublayers 7a. Therefore, cracks are not likely to progress. As a result, in the ceramic-based composite material 10, cracks are not likely to progress.

(iii) In the course of forming the matrix 3 at the above-described step S3, the closed pores 9 are formed in the matrix 3, due to a difference in an amount of volume shrinkage between the sublayers or a difference in a strain between the ceramic where a volume shrinks and the reinforcing fibers 5 where a volume does not shrink. Due to the formation of the closed pores 9, the matrix 3 is in a state where a stress generated by volume shrinkage is alleviated. In this manner, a residual stress of the matrix 3 is suppressed, and thus, formation of cracks in the matrix 3 can be suppressed.

In the matrix 3 that does not have the layer structure, large cracks are likely to be formed due to the above-described volume shrinkage. Meanwhile, the matrix 3 in the present embodiment has the layer structure. For this reason, the closed pores 9 are formed for each of the layers 7 or for each of the sublayers 7a, 7b, and 7c, and the dimensions thereof are suppressed to be equal to or smaller than a thickness of the layer 7 or the sublayer in most cases. Accordingly, the closed pores 9 are minute, and are present within the layer 7 or the sublayer and closed. Therefore, the closed pores 9 are not likely to progress into large cracks.

(iv) In the ceramic-based composite material 10 according to the present embodiment, the matrix 3 has the layer structure where a large number of layers 7 are placed on each other. Due to this layer structure, formation of cracks in the matrix 3 can be suppressed. Each of the layers 7 after being once formed of the ceramic is already heated at a high temperature in the first temperature range. Thus, it can be said that atoms or molecules in the layer 7 are strongly bonded to each other by an interatomic bond such as an ionic bond or a covalent bond. Accordingly, regarding each of the layers 7 after being once formed, a reaction of further increasing a bonding strength between the atoms is not likely to occur in subsequent heating. Thus, for the layer structure, it is considered that the layers 7 adjacent to each other are bonded with force (e.g., an intermolecular force) weaker than the interatomic bond or with partial interatomic force while the atoms or the molecules in each of the layers 7 are more strongly bonded to each other by the interatomic bond. For this reason, it can be said that the bonding strength between the layers 7 adjacent to each other is relatively lower. Accordingly, a strain is likely to occur at an interface between the layers 7. Therefore, when external force is applied to the ceramic-based composite material 10, the external force is likely to be absorbed by the strain at the interface between the layers 7. As a result, formation of cracks in the matrix 3 can be suppressed.

All of the above-described advantageous effects (i) to (iv) do not need to be achieved. In other words, any one or plural ones among the above-described effects (i) to (iv) may be achieved. According to the present invention, none of the above-described effects (i) to (iv) may be achieved.

It is considered that a state of the matrix 3 precipitated in the course of the rising and the falling of a temperature (the above-described steps S31a, S31b, and S32) varies greatly depending on a precipitation start temperature. For example, in a case of the precipitation at a lower temperature equal to or lower than 800°C, a semi-inorganic material close to an organic material is deposited as a solid around the reinforcing fibers 5 and subsequently becomes inorganic by receiving thermal energy. Meanwhile, at a higher temperature equal to or higher than 1000°C, a ratio of the thermally decomposed gas in the film-boiling gas is higher, and a semi-inorganic material close to an inorganic material is precipitated from the beginning. In other words, a ratio of the thermally decomposed gas in the film-boiling gas and an inorganic degree of the thermally decomposed gas vary depending on a temperature. It is considered that, due to this variation, a material state (an elastic modulus, a degree of crystallinity, or a composition) of the inorganic material to be formed varies, thus resulting in formation of the layer structure. Similarly, in the case of the matrix 3 formed of a material other than silicon carbide, in the course of the rising of a temperature (steps S31a and S32), one layer having the layer structure is formed while the generated ceramic (thermally decomposed precipitates) is changing from a semi-inorganic material into an inorganic material, and a semi-inorganic material is deposited on the inorganic material that is formed by the rising of a temperature (after the step S31b) after the falling of a temperature. Therefore, the layer structure is formed. Because of such a principle, even when the matrix 3 is formed of a material other than silicon carbide, the layer structure (each of the layers 7 or each of the layers 7 and the sublayers thereof) can be formed.

(Implementation Example)

In an implementation example, carbon fibers used as the reinforcing fibers 5 were prepared at the above-described step S1, liquid polycarbosilane (LPCS) as the liquid material 13 were used at the steps S2 and S3, and the configuration illustrated in FIG. 5A was used to implement the production method illustrated in the above-described flowchart of FIG. 4.

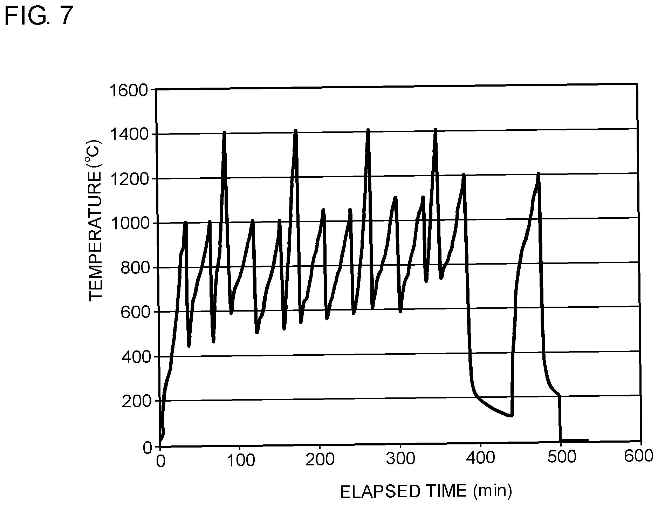

FIG. 7 is a graph illustrating a temperature change at the above-described step S3 according to the implementation example. FIG. 7 illustrates a temperature of a lower surface (i.e., a surface in contact with the heated body 12) of the upper-side fiber body 15 in FIG. 5A. In FIG. 7, the horizontal axis represents an elapsed time (min), and the vertical axis represents a temperature.

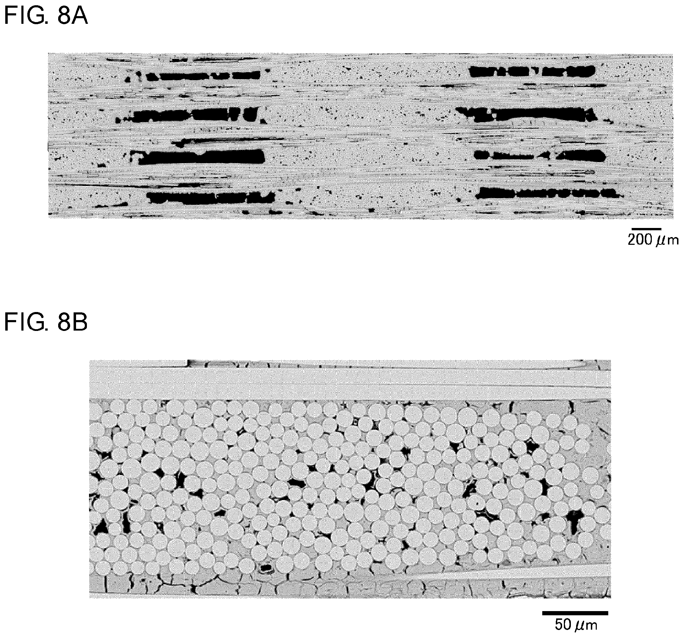

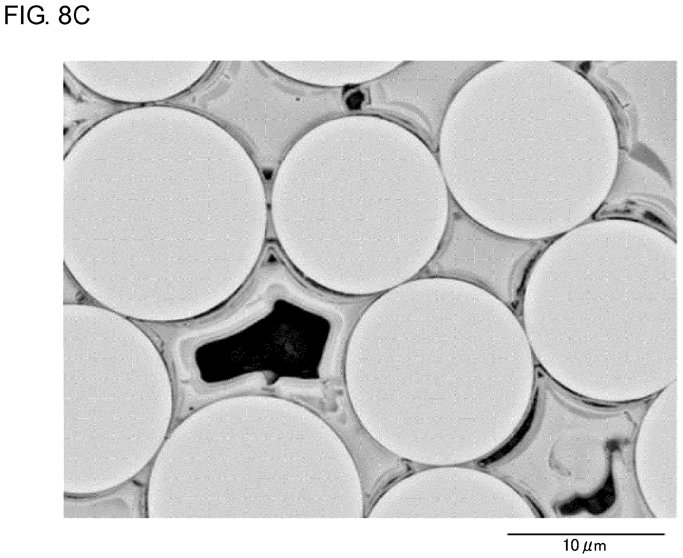

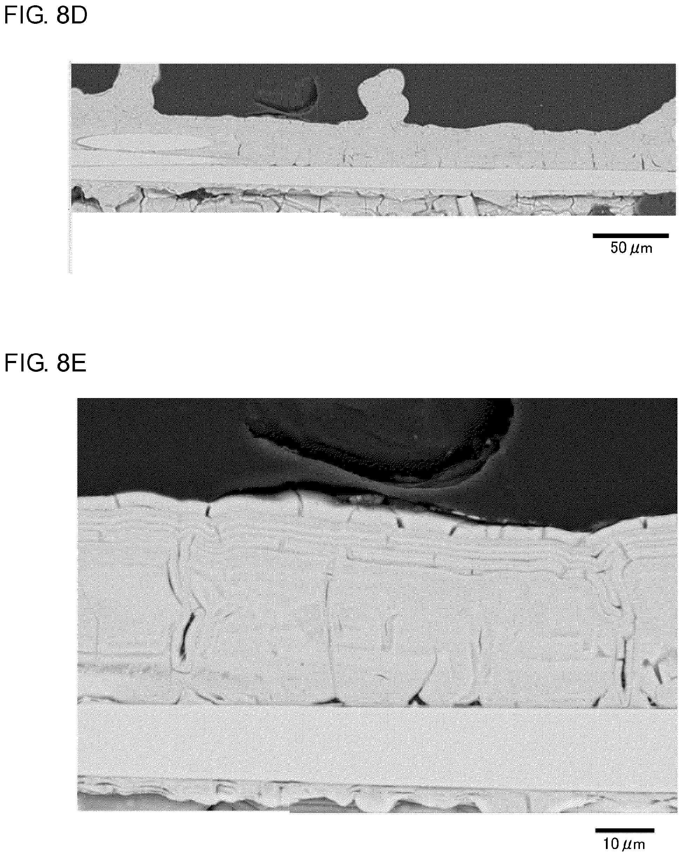

FIG. 8A to FIG. 8E are images of the ceramic-based composite material 10 fabricated by the implementation example. These images are acquired using a scanning electron microscope. FIG. 8B is a partially enlarged view of FIG. 8A, and FIG. 8C is a partially enlarged view of FIG. 8B. FIG. 8D is a partially enlarged view of FIG. 8A, and FIG. 8E is a partially enlarged view of FIG. 8D. Particularly, in FIG. 8D and FIG. 8E, the penetrating cracks 2a extending from the surface of the matrix to a depth of 5 $\mu$m or more are not present.

(Comparison Example 1)

In a comparison example 1, as in the above-described step S2, the same reinforcing fibers 5 as those in the implementation example were disposed in the same liquid material 13 as that in the implementation example, by using the configuration illustrated in FIG. 5A. In this state, the matrix was formed by film boiling substantially without rising and falling of a temperature of the reinforcing fibers 5.

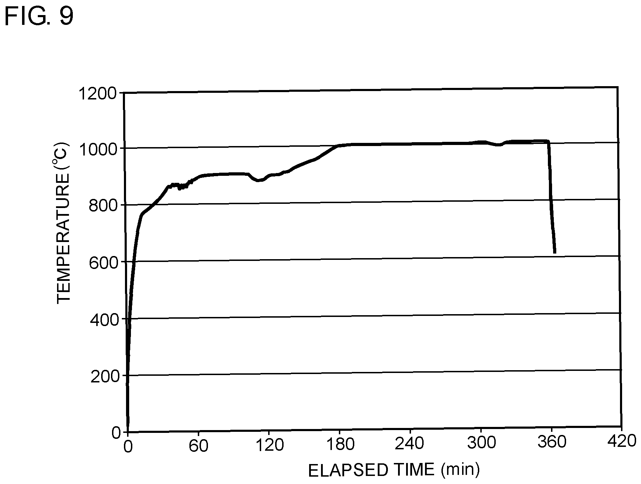

FIG. 9 is a graph illustrating a temperature change in the film boiling according to the comparison example 1. FIG. 9 illustrates a temperature of the lower surface (i.e., the surface in contact with the heated body 12) of the upper-side fiber body 15 in FIG. 5A. In FIG. 9, the horizontal axis represents an elapsed time (min), and the vertical axis represents a temperature.

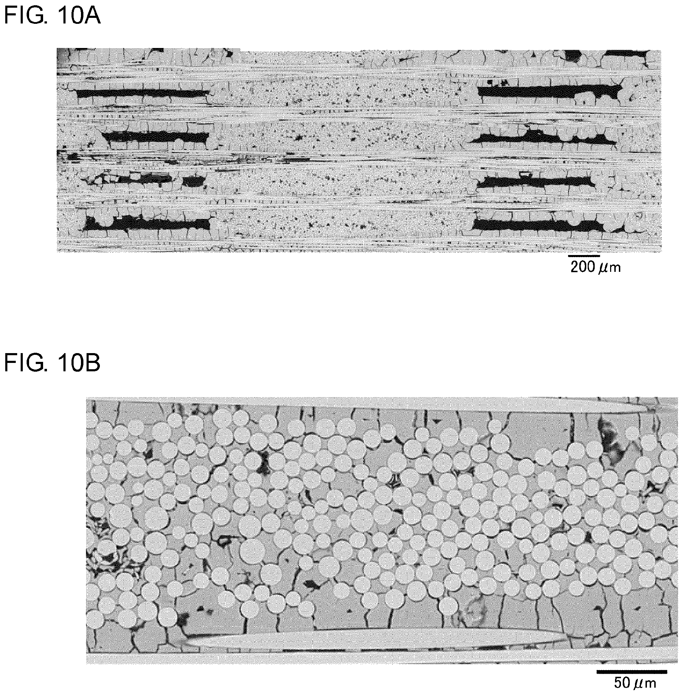

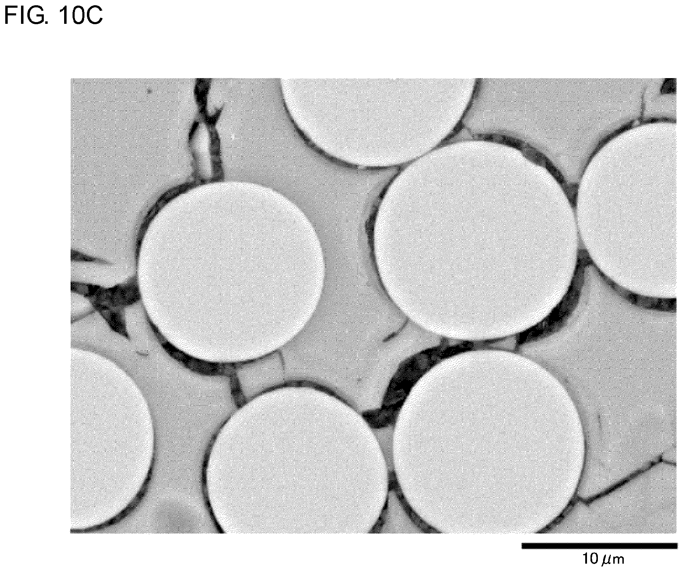

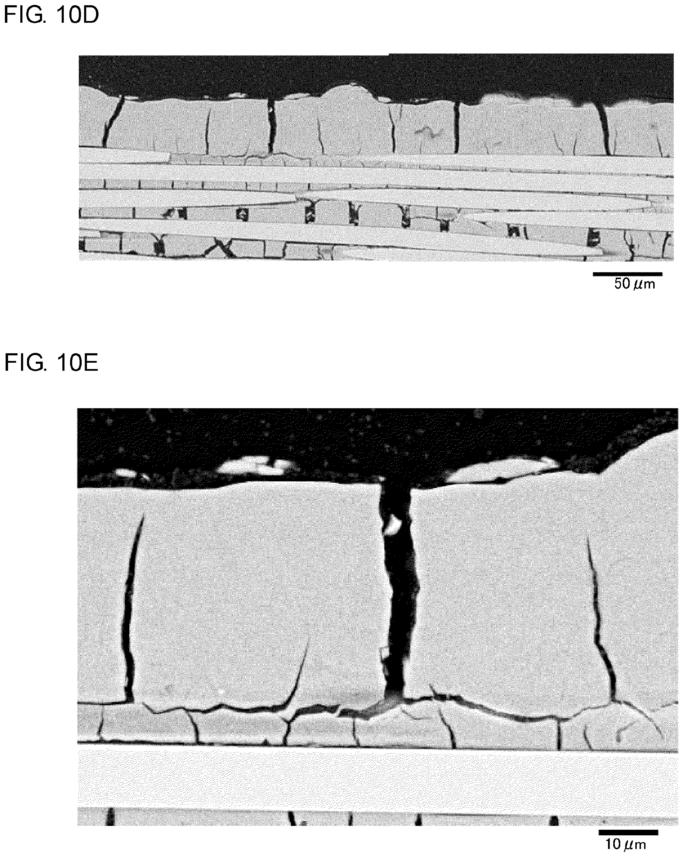

FIG. 10A to FIG. 10E are images of a ceramic-based composite material fabricated by the comparison example 1. These images were acquired using the scanning electron microscope. FIG. 10B is a partially enlarged view of FIG. 10A, and FIG. 10C is a partially enlarged view of FIG. 10B. FIG. 10D is a partially enlarged view of FIG. 10A, and FIG. 10E is a partially enlarged view of FIG. 10D. Particularly, in FIG. 10D and FIG. 10E, a large number of the penetrating cracks 2a extending from a surface of the matrix to a depth of 10 $\mu$m or more are present. In FIG. 10A to FIG. 10E, a large number of cracks only inside the matrix are present.

(Comparison Example 2)

In a comparison example 2, as in the above-described step S2, the same reinforcing fibers 5 as those in the implementation example were disposed in the same liquid material 13 as that in the implementation example, by using the configuration illustrated in FIG. 5A. In this state, the above-described step S31 was performed without performing the above-described step S32.

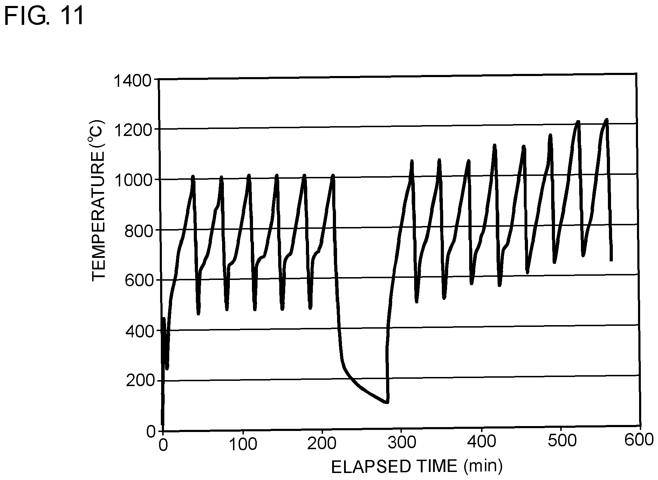

FIG. 11 is a graph illustrating a temperature change in the above-described step S31 in the comparison example 2. FIG. 11 illustrates a temperature of the lower surface (i.e., the surface in contact with the heated body 12) of the upper-side fiber body 15 in FIG. 5A. In FIG. 11, the horizontal axis represents an elapsed time (min), and the vertical axis represents a temperature.

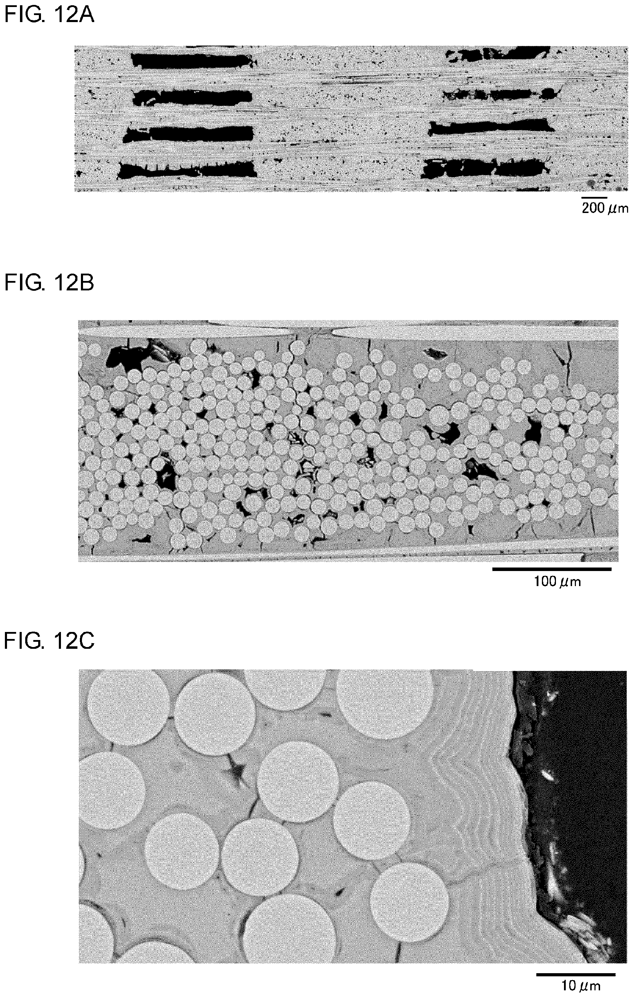

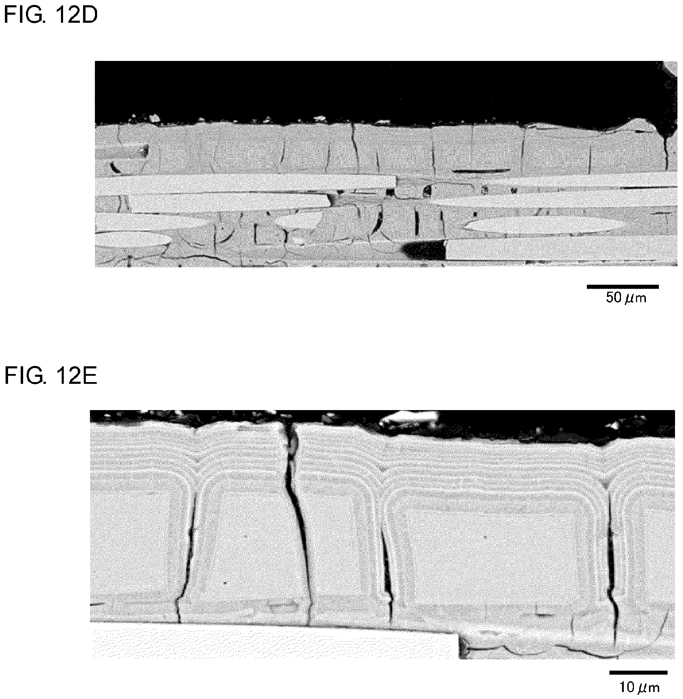

FIGS. 12A to 12E are images of a ceramic-based composite material fabricated by the comparison example 2. These images were acquired using the scanning electron microscope. FIG. 12B is a partially enlarged view of FIG. 12A, and FIG. 12C is a partially enlarged view of FIG. 12B. FIG. 12D is a partially enlarged view of FIG. 12A, and FIG. 12E is a partially enlarged view of FIG. 12D. Particularly, in FIG. 12D and FIG. 12E, a certain number of the penetrating cracks 2a extending from a surface of the matrix to a depth of 10 $\mu$m or more are present.

(Heat Exposure Test in Implementation Example)

A heat exposure test was performed on the ceramic-based composite material 10 produced by the above-described implementation example. In this test, the ceramic-based composite material 10 was placed in a high temperature environment of 1400°C for a predetermined period of time.

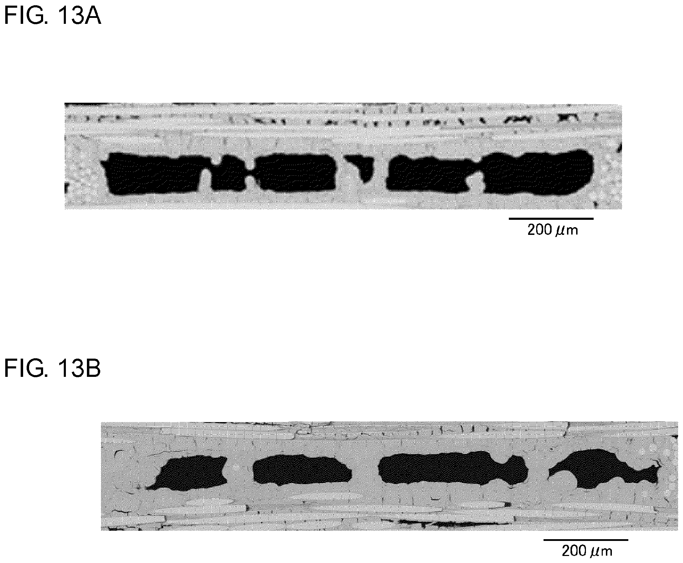

FIG. 13A is an image of the ceramic-based composite material 10 before the heat exposure test.

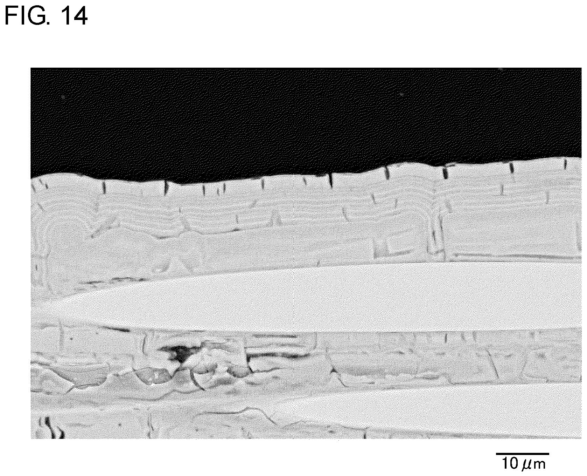

This image was acquired using the scanning electron microscope. FIG. 13B and FIG. 14 correspond to FIG. 13A and FIG. 8E described above, respectively, and are images of the ceramic-based composite material 10 after the heat exposure test. These image were acquired using the scanning electron microscope.

As can be understood from FIG. 13A and FIG. 13B, and FIG. 8E and FIG. 14, the sizes and the number of cracks in the matrix of the ceramic-based composite material 10 fabricated by the implementation example did hardly increase even after the heat exposure test.

(Heat Exposure Test in Comparison Example 1)

The same heat exposure test as that in the implementation example was performed on the ceramic-based composite material produced by the above-described comparison example 1.

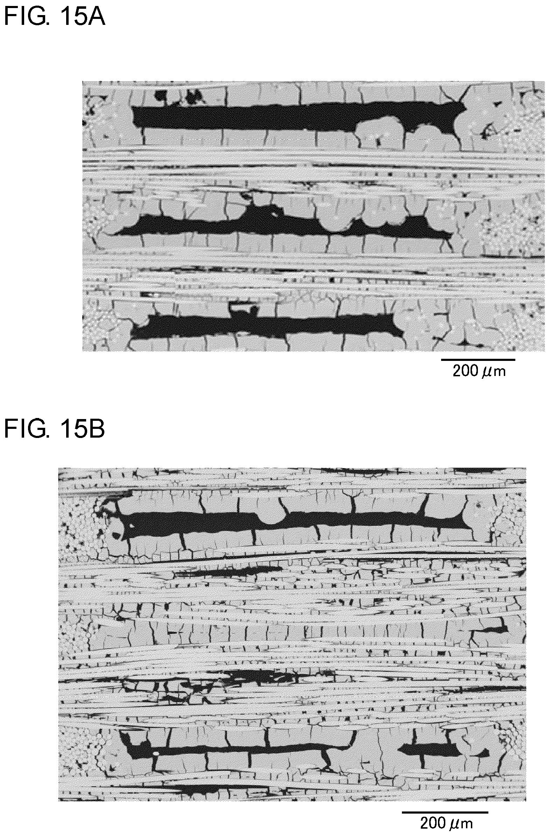

FIG. 15A is an image of the ceramic-based composite material before the heat exposure test. This image was acquired using the scanning electron microscope. FIG. 15B is an image of the ceramic-based composite material after the heat exposure test. This image was acquired using the scanning electron microscope.

As can be understood from FIG. 15A and FIG. 15B, the size or the number of cracks in the matrix of the ceramic-based composite material significantly increased after the heat exposure test, differently from the implementation example.

(Mass Decrease Amounts in Implementation Example and Comparison Example 2)

The ceramic-based composite material produced by each of the implementation example and the comparison example 2 described above was heated, and the mass thereof at each temperature was measured.

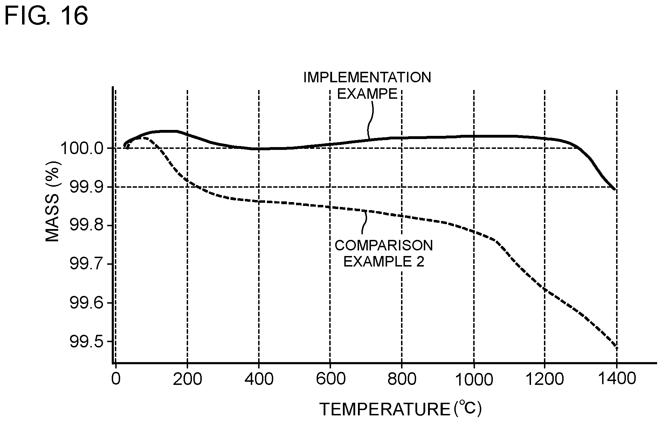

FIG. 16 illustrates the results of this experiment. In FIG. 16, the solid line indicates the implementation example, and the broken line indicates the comparison example 2. In FIG. 16, the horizontal axis represents a temperature of the ceramic-based composite material, and the vertical axis represents mass of the ceramic-based composite material by a ratio (%). In other words, a ratio of the vertical axis is a value as a result of heating the ceramic-based composite material immediately after the production by the implementation example or the comparison example 2, and indicates a ratio (%) of mass of the ceramic-based composite material at each temperature to the mass (100%) of the ceramic-based composite material immediately after the production.

As can be understood from FIG. 16, even after the ceramic-based composite material of the implementation example was heated until a temperature of the ceramic-based composite material reached 1400°C, the mass decrease ratio was slight to be about 0.1%. In the ceramic-based composite material according to the implementation example, the mass increased to about 1300°C. These results imply that the volume shrinkage causing generation of cracks is small at a high temperature.

Meanwhile, in the ceramic-based composite material according to the comparison example 2, the mass decrease ratio was larger than that in the implementation example, and was about 0.5%.

(Penetrating Crack Ratios of Implementation Example and Comparison Examples)

The following describes the penetrating crack ratio of the implementation example. However, the ceramic-based composite material 10 according to the present embodiment is not limited to the configuration having the following penetrating crack ratio as long as the ceramic-based composite material 10 has a configuration where formation of cracks are suppressed while having a heat resistance against the assumed upper limit temperature in the use environment.

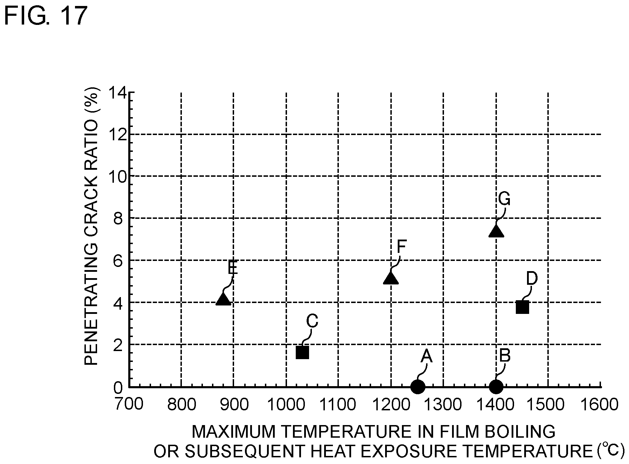

FIG. 17 illustrates measured values of the above-described penetrating crack ratio regarding the ceramic-based composite material produced by each of the implementation example and the comparison examples. In FIG. 17, the horizontal axis represents the maximum temperature (°C) in the film boiling or a heating temperature(°C) at the heat exposure step after the film boiling, and the vertical axis represents the above-described penetrating crack ratio regarding the penetrating cracks 2a extending from the outer surface of the matrix to a depth of 10 μm or more.

In FIG. 17, the circles A and B represent measured values of the penetrating crack ratio of the ceramic-based composite material 10 produced by the above-described implementation example, the circle A represents the measured value immediately after the production, and the circle B represents the measured value after the heat exposure step was performed after the production.

In FIG. 17, the squares C and D represent the measured values of the penetrating crack ratio of the ceramic-based composite material produced by the above-described comparison example 2, the square C represents the measured value immediately after the production, and the square D represents the measured value after the heat exposure step was performed after the production.

In FIG. 17, the triangles E, F, and G represent the measured values of the penetrating crack ratio of the ceramic-based composite material produced by the same method as that in the comparison example 1 except that the maximum temperature in the film boiling of the comparison example 1 was slightly lower than 900°C. The triangle E represents the measured value immediately after the production, and the triangles F and G represent the measured values after the heat exposure step was performed at 1200°C and 1400°C after the production.

As can be understood from FIG. 17, for the ceramic-based composite material 10 according to the implementation example, the penetrating crack ratio was zero immediately after the production, and was also zero without being increased even after the ceramic-based composite material 10 was heated at 1400°C by the subsequent heat exposure step. It can be seen that the matrix 3 in the implementation example includes substantially no penetrating cracks 2a functioning as an oxygen entrance path and has a high heat resistance.

Meanwhile, for the ceramic-based composite material according to the comparison example 2, the penetrating crack ratio was about 1.6% immediately after the production, and was increased to about 3.8% after the ceramic-based composite material was heated at 1450°C by the subsequent heat exposure step.

For the ceramic-based composite material according to the comparison example 1, the penetrating crack ratio was about 4.1% immediately after the production, was increased to about 5.1% after the ceramic-based composite material was heated at 1200°C by the subsequent heat exposure step, and was increased to about 7.3% after the ceramic-based composite material was further heated at 1400°C by the subsequent heat exposure step.

The present invention is not limited to the above-described embodiment, and it is apparent that various modifications may be made within the scope of the technical idea of the present invention. Any of the following modified examples 1 to 4 may be adopted alone, or two or more of modified examples 1 to 4 may be optionally adopted in combination. In this case, the matters that are not described below may be the same as those described above.

(Modified Example 1)

Before the above-described step S2, a step of forming an interface layer on an outer peripheral surface of each of the reinforcing fibers 5 may be performed. This process may be performed using a well-known method (e.g., a method described in JP 2003-321277 A). In this case, the interface layer is formed at a boundary between each of the reinforcing fibers 5 and the matrix 3. The interface layer may be a layer including boron nitride. In the case of providing the interface layer, even when cracks are formed and progress to the reinforcing fibers 5, the interface layer can prevent the cracks from reaching the reinforcing fibers 5.

(Modified Example 2)

The material forming the matrix 3 may be a material other than silicon carbide. In this case, an inorganic polymer material that is a material for a ceramic including an alkoxide solution and has a molecular weight low enough to be in a liquid state may be used as the liquid material 13 in the above-described film boiling. Any of other materials may be used as the liquid material 13. Accordingly, the liquid material 13 in the above-described film boiling may be a liquid material other than the above-described LPCS. For example, the liquid material 13 may be borazine, methyltrichlorosilane, cyclohexane, a silicon alkoxide solution, an aluminum alkoxide solution, a mixture of a silicon alkoxide solution and an aluminum alkoxide solution, or a zirconium alkoxide solution.

When the liquid material 13 is borazine, ceramic formed by heating at the above-described step S3 is boron nitride (BN). Boron nitride has low adhesiveness to silicon carbide. Accordingly, when the reinforcing fibers 5 are silicon carbide fibers, propagation of cracks can be suppressed at an interface between the matrix 3 of boron nitride and the reinforcing fibers 5 of silicon carbide.

When the liquid material 13 is methyltrichlorosilane, ceramic formed by heating at the above-described step S3 is silicon carbide (SiC) as in the case where the liquid material 13 is polycarbosilane (LPCS).

When the liquid material 13 is cyclohexane, ceramic formed by heating at the above-described step S3 is carbon. This carbon has the same function as boron nitride.

When the liquid material 13 is a silicon alkoxide solution, ceramic formed by heating at the above-described step S3 is silicon dioxide. The silicon alkoxide solution is cheaper than LPCS.

When the liquid material 13 is an aluminum alkoxide solution, ceramic formed by heating at the above-described step S3 is alumina. The aluminum alkoxide solution is cheaper than LPCS.

When the liquid material 13 is a mixture of a silicon alkoxide solution and an aluminum alkoxide solution, ceramic formed by heating at the above-described step S3 is mullite.

When the liquid material 13 is a zirconium alkoxide solution, ceramic formed by heating at the above-described step S3 is zirconia. Zirconia is ceramic having a higher melting point than silicon carbide, and thus functions as the matrix without melting even in an ultra-high temperature environment.

According to the present invention, the liquid material 13 used at the step S3 is not limited to the above-described specific examples, and may be any of other liquid materials. For example, any of other metal alkoxide solutions may be used as the liquid material 13 used at the step S3. In this case, ceramic formed by heating at the above-described step S3 may be oxide ceramic. In this case, the liquid material 13 used at the step S3 may be, for example, a mixture of three alkoxide solutions (alkoxydes) such as one as described in Non-Patent Literature 2, such that the ceramic formed at the step S3 is barium aluminosilicate ($BaAl_2Si_2O_8$). The matrix 3 formed from the liquid material 13 may be at least partially crystallized.

When the matrix 3 is formed of mullite, the liquid material 13 used in the above-described film boiling may be, for example, a mixed solution of a plurality of alkoxide solutions (alkoxydes) as described above in Non-Patent Literature 3. The matrix 3 formed from the liquid material 13 may be at least partially crystallized.

(Modified Example 3)

The above-described attachment tool is not limited to the above-described configuration. In other words, the above-described attachment tool may be an attachment tool to which a fiber body constituting a ceramic-based composite material is attached, and this attachment tool may be disposed in a liquid material for the matrix together with the fiber body to perform film boiling on the fiber body.

(Modified Example 4)

In the production method according to the above-described embodiment, the step S31b of causing a temperature of the reinforcing fibers 5 to fall to become a temperature in the above-described second temperature range may be omitted. In this case, at the step S31, a state where the reinforcing fibers 5 in the liquid material 13 are heated at the matrix forming temperature (the temperature in the above-described first temperature range) may be kept for a predetermined period of time. After the heating at the step S31 is kept for the predetermined period of time, the process proceeds to the step S32. In this case, the other matters are the same as those described above.

Even in this modified example, repeating the steps S31 and S32 described above can impart a heat resistance to the matrix 3 while forming the matrix 3.

**REFERENCE SIGNS LIST**

2a: penetrating crack
2b: intermediately stopped crack
3: matrix
3a: outer surface
5: reinforcing fiber
6: interface layer
7: layer
7a, 7b, 7c: sublayer
9: closed pore
10: ceramic-based composite material
11: treatment vessel
11a: cover member
11a1: penetration hole
11a2: gas discharge hole
11b: gas introduction hole
12: heated body
12a: outer periphery
13: liquid material for matrix
14: heat insulating plate
15: fiber body

15a: outer periphery
16: porous body (wire net)
17: acting mechanism
17a: bolt
17b: nut
18: heat insulating member
19: wire
21: coil
23: suspension unit
23a: plate-shaped member
23a1: coupling portion
23b: rod-shaped member
100: attachment tool

**Claims**

1. A method for producing a ceramic-based composite material including a matrix and reinforcing fibers provided in the matrix, the method comprising:

   a step (A) of disposing the reinforcing fibers in a liquid material for the matrix;
   a step (B) of heating the reinforcing fibers in the liquid material such that a temperature of the reinforcing fibers becomes a matrix forming temperature; and
   a step (C) of heating the reinforcing fibers in the liquid material such that a temperature of the reinforcing fibers becomes a heat resistance imparting temperature, wherein
   the heat resistance imparting temperature is a temperature higher than the matrix forming temperature, and the method comprises repeating the step (B) and the step (C).

2. The method for producing the ceramic-based composite material according to claim 1, wherein

   the step (B) includes
   a step (B 1) of causing a temperature of the reinforcing fibers to rise to reach a matrix forming temperature in a first temperature range in which the matrix is deposited to the reinforcing fibers, and
   a step (B2) of causing a temperature of the reinforcing fibers to fall to reach a temperature in a second temperature range in which the matrix is not deposited to the reinforcing fibers, and
   each turn of the repeated step (B) includes repeating the step (B 1) and the step (B2).

3. The method for producing the ceramic-based composite material according to claim 1 or 2, wherein (C) includes increasing the temperature of the reinforcing fibers such that the temperature of the reinforcing fibers reaches a heat resistance imparting temperature in a third temperature range for imparting heat resistance in a usage environment of the ceramic-based composite material.

4. The method for producing the ceramic-based composite material according to claim 2, wherein
a lower limit of the second temperature range is equal to or higher than a boiling point of the liquid material, or an upper limit of the second temperature range is lower than the boiling point of the liquid material.

5. A ceramic-based composite material that has been produced by the method according to any one of claims 1 to 4.

FIG. 1

## FIG. 2A

FIG. 2B

EP 4 534 508 A1

FIG. 2C

EP 4 534 508 A1

FIG. 3

# FIG. 4

A flowchart:

START → **S1** PREPARE REINFORCING FIBERS (FIBER BODY)

→ **S2** DISPOSE REINFORCING FIBERS (FIBER BODY) IN LIQUID MATERIAL FOR MATRIX

→ **S3** (dashed box)

$k \rightarrow 0$

MATRIX FORMATION — **S31** (dashed box)

**S31a** CAUSE TEMPERATURE OF REINFORCING FIBERS TO RISE TO TEMPERATURE IN FIRST TEMPERATURE RANGE

**S31b** CAUSE TEMPERATURE OF REINFORCING FIBERS TO FALL TO TEMPERATURE IN SECOND TEMPERATURE RANGE

**S31c** IS TEMPERATURE RISING AND FALLING REPEATED PREDETERMINED NUMBER OF TIMES?

NO → $k \rightarrow k+1$ → (back to S31a)

YES

TREATMENT FOR HEAT RESISTANCE

**S32** CAUSE TEMPERATURE OF REINFORCING FIBERS TO RISE TO TEMPERATURE IN THIRD TEMPERATURE RANGE

ARE STEPS REPEATED SET NUMBER OF TIMES?

NO → $k \rightarrow 0$ → (back to S31b)

YES → END

FIG. 5A

FIG. 5B

FIG. 5C

FIG. 6

FIG. 7

FIG. 8A

200 μm

FIG. 8B

50 μm

FIG. 8C

10 μm

FIG. 8D

50 μm

FIG. 8E

10 μm

FIG. 9

FIG. 10A

200 μm

FIG. 10B

50 μm

FIG. 10C

10 μm

FIG. 10D

50 μm

FIG. 10E

10 μm

FIG. 11

## FIG. 12A

200 μm

## FIG. 12B

100 μm

## FIG. 12C

10 μm

FIG. 12D

50 μm

FIG. 12E

10 μm

FIG. 13A

200 μm

FIG. 13B

200 μm

FIG. 14

10 μm

FIG. 15A

200 μm

FIG. 15B

200 μm

FIG. 16

FIG. 17

## INTERNATIONAL SEARCH REPORT

| International application No. |
|---|
| **PCT/JP2023/019942** |

### A. CLASSIFICATION OF SUBJECT MATTER

***C04B 35/80***(2006.01)i; ***C04B 35/653***(2006.01)i
FI: C04B35/80; C04B35/653

According to International Patent Classification (IPC) or to both national classification and IPC

### B. FIELDS SEARCHED

Minimum documentation searched (classification system followed by classification symbols)

C04B35/80; C04B35/653

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580/JSTChina (JDreamIII)

### C. DOCUMENTS CONSIDERED TO BE RELEVANT

| Category* | Citation of document, with indication, where appropriate, of the relevant passages | Relevant to claim No. |
|---|---|---|
| A | JP 2002-029846 A (KAWASAKI HEAVY IND LTD) 29 January 2002 (2002-01-29)<br>claim 1 | 1-5 |
| A | JP 08-169761 A (TOSHIBA CORP) 02 July 1996 (1996-07-02)<br>claim 1 | 1-5 |
| A | 山内　宏, 膜沸騰（ＦＢ）法による低コストＣ／Ｃおよび周辺技術の開発, 炭素, 2018, no. 284, pp. 143-150<br>entire text, all drawings, (YAMAUCHI, Hiroshi. Development of low-cost C/C, related technology using a film-boiling process. TANSO.) | 1-5 |
| A | JP 2020-100559 A (UNIV KYOTO) 02 July 2020 (2020-07-02)<br>claim 1 | 1-5 |
| P, A | JP 2022-089297 A (IHI AEROSPACE CO LTD) 16 June 2022 (2022-06-16)<br>claims 1-17 | 1-5 |
| P, A | WO 2022/118962 A1 (IHI AEROSPACE CO LTD) 09 June 2022 (2022-06-09)<br>claims 1-8, fig. 1 | 1-5 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 July 2023** | **01 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/019942**

| C. | DOCUMENTS CONSIDERED TO BE RELEVANT |
|---|---|

| Category* | Citation of document, with indication, where appropriate, of the relevant passages | Relevant to claim No. |
|---|---|---|
| P, A | WO 2022/118963 A1 (IHI AEROSPACE CO LTD) 09 June 2022 (2022-06-09)<br>claims 1-9, fig. 1 | 1-5 |

Form PCT/ISA/210 (second sheet) (January 2015)

**INTERNATIONAL SEARCH REPORT**
Information on patent family members

International application No.

**PCT/JP2023/019942**

| Patent document cited in search report | | | Publication date (day/month/year) | Patent family member(s) | | | Publication date (day/month/year) |
|---|---|---|---|---|---|---|---|
| JP | 2002-029846 | A | 29 January 2002 | (Family: none) | | | |
| JP | 08-169761 | A | 02 July 1996 | (Family: none) | | | |
| JP | 2020-100559 | A | 02 July 2020 | US claim 1 WO | 2017/0341986 2016/093360 | A1 A1 | |
| JP | 2022-089297 | A | 16 June 2022 | (Family: none) | | | |
| WO | 2022/118962 | A1 | 09 June 2022 | JP claims 1-8, fig. 1 | 2022-89299 | A | |
| WO | 2022/118963 | A1 | 09 June 2022 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003321277 A

**Non-patent literature cited in the description**

- **MIN MEI et al.** Preparation of C/SiC composites by pulse chemical liquid-vapor deposition process. *Materials Letters*, 2012, vol. 82, 36-38
- **C. BESNARDA et al.** Synthesis of hexacelsian barium aluminosilicate by film boiling chemical vapour process. *Journal of the European Ceramic Society*, 2020, vol. 40, 3494-3497
- **MASANORI SHIMIZU et al.** Crystallization Behavior and Change in Surface Area of Alkoxide-Derived Mullite Precursor Powders with Different Compositions. *Journal of the Ceramic Society of Japan*, 1997, vol. 105 (2), 131-135